# EUROPEAN PATENT SPECIFICATION

(11) **EP 1 798 599 B1**
(45) Date of publication and mention of the grant of the patent: **06.08.2008**
(21) Application number: 06025581.7
(22) Date of filing: 11.12.2006
(51) Int. Cl.: G03F 7/075, G03F 7/09, C08G 77/58, C08K 3/22, C08L 83/14

(54) **Antireflection film composition, patterning process and substrate using the same**
Antireflexschichtzusammensetzung, Musterungsverfahren und diese verwendendes Substrat
Composition de film antireflet, procédé de formation de motif et substrat l'utilisant

(30) Priority: 14.12.2005 JP 2005360202
(43) Date of publication of application: 20.06.2007
(73) Proprietor: Shin-Etsu Chemical Co., Ltd., Tokyo 100-0005 (JP)
(72) Inventor: Iwabuchi, Motoaki New Funct.Materia.Resea.Center, Kubiki-ku Jyoetsu-shi Niigata-ken (JP); Ogihara, Tsutomu New Funct. Materia. Resea. Center, Kubiki-ku Jyoetsu-shi Niigata-ken (JP); Asano, Takeshi New Funct. Materia. Resea. Center, Kubiki-ku Jyoetsu-shi Niigata-ken (JP); Ueda, Takafumi New Funct. Materia. Resea. Center, Kubiki-ku Jyoetsu-shi Niigata-ken (JP)
(74) Representative: Wibbelmann, Jobst

(56) References cited:
- US-A- 5 328 975
- US-A1- 2004 253 461
- US-A1- 2005 112 383
- US-B1- 6 420 088

## Description

### BACKGROUND OF THE INVENTION

### Field of the Invention:

The present invention relates to an antireflection film composition suitable for forming an intermediate resist film in the multilayer resist process used for microprocessing in production processes of semiconductor devices or the like; a patterning process using the antireflection film composition suitable for exposure to a far ultraviolet radiation, KrF excimer laser light, ArF excimer laser light (193 nm), F₂ laser light (157 nm), Kr₂ laser light (146 nm), Ar₂ laser light (126 nm), soft X-ray, an electron beam, an ion beam, X-rays, or the like, for example, when a process layer of a substrate is a low dielectric constant insulator film; and a substrate using the antireflection film composition.

### Description of the Related Art:

With a tendency of realizing high integration and high-speed of LSI, a finer pattern rule has been demanded in recent years. The lithography technique with optical exposure, which is used for general purpose at present, is reaching an inherent limiting resolution derived from a wavelength of a light source.

There is widely used optical exposure using g line (436 nm) or i line (365 nm) of a mercury-vapor lamp as a light source for lithography when a resist pattern is formed. It has been considered that a method of using an exposure light with a shorter wavelength is effective as a means for obtaining a further finer pattern. For this reason, for example, KrF excimer laser (248 nm) with a shorter wavelength is used as an exposure light source instead of i line (365 nm) for mass-production process of a 64 M bit DRAM processing method. However, a light source with far shorter wavelength is needed to manufacture DRAM with integration degree of 1 G or more which needs still finer processing techniques (for example, a processing size is 0.13 µm or less). Accordingly, lithography with ArF excimer laser (193 nm) has been particularly examined.

In the early stage of KrF lithography, there has been developed a stepper in which an achromatic lens or a reflecting optical system and a broadband light are combined. However, the combination of the narrow spectrum laser light and the refracting-optical-system lens has been dominant, because the achromatic lens or an aspherical surface reflecting optical system is not accurate enough. A phenomenon is well known from a long time ago that interference of incident light and reflected light from a substrate generally causes generation of standing waves in exposure with a single wavelength. Moreover, another phenomenon called halation is also known that light is condensed or scattered due to irregularity of a substrate. Both of the standing waves and the halation cause dimension variation of a pattern line width, collapse of pattern profile, or the like. Use of a coherent monochromatic light amplifies the standing waves and the halation further as wavelength gets shorter. For this reason, in order to suppress the halation and the standing waves, there have been proposed a method of adding a light absorber to a photoresist film composition and a method of forming an antireflection film on an upper resist layer or on a substrate.

However, the method of adding a light absorber causes a problem that a resist pattern has taper profile. In addition, as a wavelength gets shorter and a pattern gets finer in recent years, the problem of variation of pattern dimension due to the standing waves and the halation has become serious. Then, it has become impossible to solve the problem with the method of adding a light absorber.

On the other hand, use of the transmission-type upper-layer antireflection film can theoretically reduce only standing waves, but cannot reduce the halation. Moreover, an ideal refractive index of the upper-layer antireflection film for annihilating standing waves is a square root of the refractive index of the resist film. Accordingly, when the refractive index of a resist film made of polyhydroxystyrenes used in KrF lithography is 1.8, the ideal value is 1.34. When the refractive index of an alicyclic acrylic resist film used for ArF lithography is 1.6, the ideal value is 1.27.

Compositions with such low refractive index are restricted to perfluoro compounds. In addition, an upper-layer antireflection film composition is required to be water-soluble because an upper-layer antireflection film that can be stripped during development with an alkaline solution is advantageous for conducting the process. Then, in order to make highly hydrophobic perfluoro compositions water-soluble, hydrophilic substituents are introduced to the compositions. This increases the refractive index of the compositions: the refractive index becomes about 1.42 in KrF lithography, and about 1.5 in ArF lithography. Therefore, when a pattern of 0.20 µm or less is formed in KrF lithography, it has become impossible to suppress the influence of the standing waves only by using the combination of a light absorber and the upper-layer antireflection film. In ArF lithography, the upper-layer antireflection film hardly functions to solve the problem by the reason mentioned above. And also in KrF lithography, control of a line width becomes severe because of further decrease of the line width in future. Therefore, it has become necessary to form an antireflection film under a resist film.

The antireflection film under the resist film can reduce reflection from a substrate to 1% or less in the case of using a high reflective substrate such as poly silicon or aluminum by selecting a composition with an optimal refractive index (n value) and an optimal extinction coefficient (k value) and forming the antireflection film with a suitable thickness, and thereby producing an extremely advantageous effect.

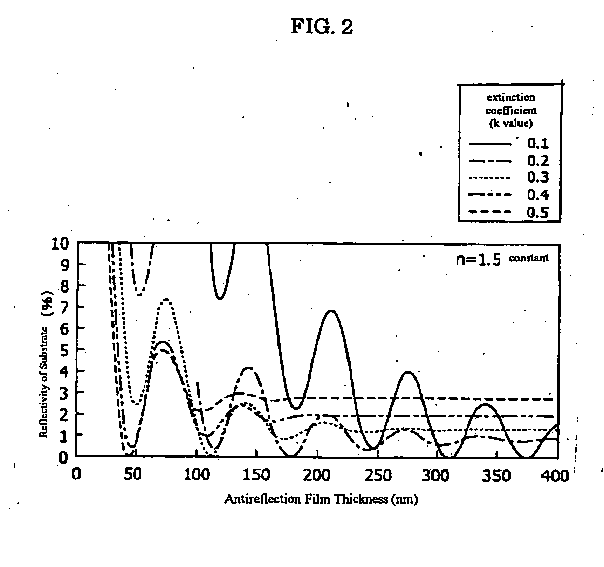

For example, in the case that the refractive index of a resist film is 1.8 at a wavelength of 193 nm, and when the refractive index n (a real part of a refractive index) of an lower antireflection film is 1.5, the extinction coefficient k (a imaginary part of a refractive index) of the lower antireflection film is 0.5, and a thickness of the antireflection film is 42 nm, a reflectivity will become 0.5 % or less (see Fig.2). This reveals that use of the lower antireflection film is extremely effective.

Antireflection film compositions can be roughly classified into inorganic compositions and organic compositions.

An example of the inorganic compositions is a SiON film. This film is formed by CVD with a mixed gas of silane and ammonia or the like. The SiON film has an advantage that etching load to a resist film is small because the SiON film has high etch selection ratio to the resist film. However, application of the SiON film is restricted because it is difficult to strip the SiON film. The SiON film has another drawback that footing profile is likely caused in the case of a positive resist, and an undercut profile is likely caused in the case of a negative resist because the SiON film contains a nitrogen atom and is basic.

The organic compositions have advantages in that films can be formed by spin coating without special equipments such as CVD system or sputtering system, the films can be stripped together with a resist film, pattern profile of the films is good without footing profile or the like being caused, and the films have an excellent adhesion property with a resist film. Accordingly, a lot of antireflection films based on organic compositions have been proposed: for example, a composition containing a condensation product of a diphenylamine derivative and a formaldehyde modified melamine resin, an alkali soluble resin and a light absorber (see Japanese Publication of Examined Application No. H07-69611); a reaction product of a maleic anhydride copolymer and diamine type light absorber (see U.S. Patent No. 5294680 specification); compositions containing a resin binder and a methylol melamine heat crosslinking agent (see Japanese Unexamined Patent Application Publication No. H06-118631;, a composition based on an acrylate resin which has a carboxylic acid group, an epoxy group, and a light-absorption group in a molecule (see Japanese Unexamined Patent Application Publication No. H06-118656); compositions containing methylol melamine and a benzophenone light absorber (see Japanese Unexamined Patent Application Publication No. H08-87115); compositions in which a low molecule light absorber is added to a polyvinyl alcohol resin (see Japanese Unexamined Patent Application Publication No. H08-179509), and so on. In all of these antireflection film compositions, a light absorber is added to a binder polymer, or a light-absorption group is introduced into a polymer as a substituent. However, such antireflection film compositions have a drawback that dry etch selection ratio to a resist film is not so high because many of the light absorbers have an aromatic group or a double bond, and addition of the light absorber increases dry etching resistance of antireflection films. A finer pattern is used, and thinner resist films are increasingly used. Furthermore, acrylic or alicyclic polymers will be used as resist film compositions in the next generation ArF exposure. As a result, etching resistance of resist films will be lowered. For the reasons mentioned above, etching is becoming a serious problem, and thus antireflection films with high etch selection ratio to resist films, that is, antireflection films to be etched sufficiently faster than resist film are demanded.

Light absorbers giving optimal extinction coefficient to antireflection films have been examined. An anthracene type is particularly proposed in KrF lithography, and a phenyl type in ArF lithography. However, as explained above, anthracene and phenyl are also substituents which have high dry etching resistance. Accordingly, even if a polymer having low etching resistance such as an acrylic resin is used as a polymer backbone from which the organic groups (anthracene and phenyl) are suspended, practical use of the polymer is restricted.

By the way, it is recognized that silicon-containing compositions generally have high etch rate and high etch selection ratio to resist films under etching conditions with fluorocarbon gases. Accordingly, it is considered that use of silicon-containing antireflection films enhances etch selection ratio to resist films remarkably.

Furthermore, thinner photoresist films are used as higher resolution has been achieved in recent years. Although enhancement of etching resistance of photoresist films is demanded as the films get thinner, the etching resistance does not meet the demand at present. Then, the hard mask method is used to transfer patterns on thin photoresist films.

For example, a trilayer process is suggested: in the process, an organic film is formed on a substrate; silica glass is spin-coated on the organic film; an overlying resist pattern is transferred to the silica glass layer; the pattern is transferred to the organic film with oxygen gas etching; and finally the substrate is processed (See Japanese Patent Publication No. 3118887 ; and Japanese Unexamined Patent Application Publication No. 2000-356854). A silica glass layer and a silsesquioxane polymer composition functioning also as an antireflection film are suggested (See Japanese Unexamined Patent Application Publication No. H05-27444; Japanese Unexamined Patent Application Publication No. H06-138664; Japanese Unexamined Patent Application Publication No. 2001-53068; Japanese Unexamined Patent Application Publication No. 2001-92122; and Japanese Unexamined Patent Application Publication No. 2001-343752). Furthermore, U.S. Patent No. 6420088 discloses a silsesqui-oxan polymer, and Published Japanese Translations of PCT International Publication for Patent Application No.2003-502449 discloses compositions based on Spin On Glass compositions that can function as both an antireflection film and a hard mask.

However, every silicon-containing polymer lacks preservation stability, and causes a serious problem that a film thickness varies when the film is actually used. Furthermore, resist patterns on films made from such Spin On Glass compositions by crosslinking of siloxane do not have straight wall profile, and generate deformed profile such as footing profile, reverse tapered profile, or film residue on the profile. This is thought to be caused because diffusion of acid, base, or the like from a resist layer to an antireflection film layer, or from an antireflection film layer to a resist layer is occurred at interstice of siloxane bondings.

In addition, in the trilayer process in which an organic film is formed on a substrate, an antireflection film is formed on the organic film, and a photoresist film is formed on the antireflection film, when a process layer of the substrate is a porous film such as a silicon-containing low dielectric constant film, there is a problem that conducting dry etching of the process layer and removal of the antireflection film simultaneously after a pattern is transferred to the organic film damages the process layer and a pattern on the process layer is collapsed.

There is also another problem that removing the antireflection film with dry etching causes residue of silicon compound to remain on the surface of the organic layer, this residue functions as a mask at the time of O₂ ashing for removing the organic layer in the subsequent step, and organic substance that should be removed remains on the substrate.

Then, an antireflection film that can be removed easily with wet stripping has been demanded for an intermediate resist film.

By the way, as to processing techniques for silicon-containing low dielectric constant compositions with a relative dielectric constant of 2.7 or less, review over the whole steps such as cleaning, etching, or CMP; and novel compositions suitable for the steps are demanded.

For example, Spear Richard et al. suggests Spin On Glass compositions as an antireflection coating/filling composition in Via First Dual Damascene Process (see Published Japanese Translations of PCT International Publication for Patent Application No.2003-502449; U.S. Patent No.6268457; and U.S. Patent No.6506497). The Spin On Glass compositions have similar structures to silica low dielectric constant films, and etching the Spin On Glass films with oxygen gases rather damage silica low dielectric constant films due to their porous structure, while dry etching with CF gases does not harm pattern profile. Furthermore, it is difficult to obtain enough selection ratio of the Spin On Glass films when the films are subjected to wet stripping, and the films cannot be stripped or it is difficult to control shape of the films.

On the other hand, use of organic filling compositions causes a problem that deformation tend to be generated in the vicinity of an interface of an organic film and a low dielectric constant film at the time of patterning the low dielectric constant film with dry etching with fluorocarbon gases after dry etching with oxygen gases.

Siloxane compositions exhibit excellent etching selectivity to resist films made of carbon organic compositions, but it is difficult to obtain excellent etching selectivity to insulator films made of silicon-containing compositions, particularly when dry etching is conducted. When siloxane compositions are subjected to wet stripping, it is also difficult to obtain enough etching selection ratio except that there is large difference of condensation degree between the siloxane compositions and resist films. Use of siloxane compositions with low condensation degree for obtaining high etch selection ratio causes problems such as intermixing with the overlying resist layer and footing profile of a resist pattern on the overlying layer. Furthermore, it is known that high etch selection ratio as expected cannot be obtained because condensation degree of the siloxane compositions increases through etching and baking processes.

Besides polysiloxane compositions, polytitanoxane and polytitanosiloxane are suggested (see Japanese Unexamined Patent Application Publication No. H11-258813). Furthermore, a composition of polysiloxane and organic titanium chelate monomer is suggested (see Japanese Unexamined Patent Application Publication No. 2005-173552). However, these antireflection film compositions are used for forming a bottom layer film of a bilayer resist film. In lithography using a three or more layers resist film, films made from the compositions have a drawback that the films cannot be used as an etching mask because such films do not have enough etching resistance which is required when an underlying organic film is etched.

In addition, as higher integration degree of semiconductor integrated circuits is achieved, more advanced microprocessing techniques are demanded. Especially, in processing techniques for Cu/ULK interconnect based next generation semiconductor devices, a processing method for successfully using compositions that lacks chemical or physical strength is demanded.

As mentioned above, in an antireflection film composition for forming an intermediate resist film, the following properties are demanded: the antireflection film exhibits high etch selection ratio to a photoresist film and high preservation stability; an excellent pattern can be formed on an overlying photoresist film when the antireflection film is formed; and the antireflection film can be easily removed with wet stripping.

### SUMMARY OF THE INVENTION

The present invention has been accomplished to solve the above-mentioned problems, and an object of the present invention is to provide a novel antireflection film composition (a silicon-containing filling composition) that exhibits high etch selection ratio to a photoresist film, namely being etched faster than the photoresist film; that forms a dense inorganic film, whereby an excellent pattern can be formed on the overlying photoresist film; that can be easily removed with wet stripping; that has high preservation stability and excellent dry etching resistance; and that is suitable for forming an intermediate resist film of a multilayer resist film. Another object of the present invention is to provide a patterning process in which an antireflection film is formed over an organic film over a substrate by using the antireflection film composition; and a substrate having the antireflection film as an intermediate resist film.

In order to achieve the above object, the present invention provides an antireflection film composition for forming an intermediate resist film in a multilayer resist element used in lithography comprising: at least
a polymer obtained by reacting a chelating agent with a polymer having a repeating unit represented by the following general formula (1), 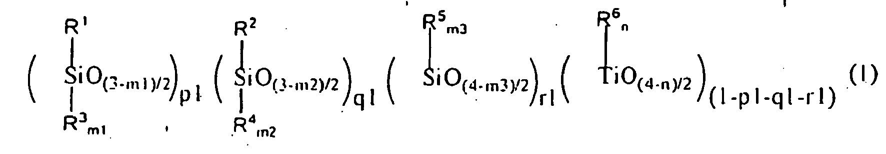 ,wherein R¹ represents a monovalent organic group that reacts with crosslinker and/or any one or more of the organic groups R², R³, R⁴, and R⁶ to form crosslinking; R² represents a monovalent organic group having a light absorbing group; R⁵ represents the same or different group that does not crosslink with crosslinker or organic groups in the formula (1); p1, q1 and r1 satisfy 0<p1<1, 0<q1<1, 0≦r1<1 and 0.5<p1+q1+r1<1; R³ represents any one of a hydroxy group, an alkyl group having 1-6 carbon atoms, an alkoxy group having 1-4 carbon atoms, and the same groups as defined for R² or R⁵; R⁴ represents the same groups as defined for R¹, R³ or R⁵ ; m1 satisfies 0 ≦ m1≦1 ; m2 satisfies 0≦m2≦1 ; m3 satisfies 0≦m3≦2 ; R⁶ independently represents an alkoxy group having 1-6 carbon atoms or a hydroxy group; and n satisfies 0≦n≦3 ;
an organic solvent; and
an acid generator.

Furthermore, the present invention provides an antireflection film composition for forming an intermediate resist film in a multilayer resist element used in lithography comprising: at least
a composition obtained by reacting a chelating agent with a composition containing a polymer having a repeating unit represented by the following general formula (2) and titanium oxide sol in the proportions of 100 parts of the polymer to 1-50 parts of the sol, 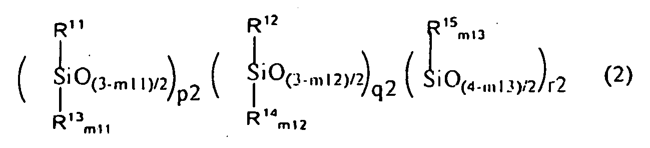 ,wherein R¹¹ represents a monovalent organic group that reacts with crosslinker and/or any one or more of the organic groups R¹², R¹³, and R¹⁴, to form crosslinking; R¹² represents a monovalent organic group having a light absorbing group; R¹⁵ represents the same or different group that does not crosslink with crosslinker or organic groups in the formula (2); p2, q2 and r2 satisfy 0<p2<1, 0<q2<1, 0≦r2<1 and 0<p2+q2+r2≦1; R¹³ represents any one of a hydroxy group, an alkyl group having 1-6 carbon atoms, an alkoxy group having 1-4 carbon atoms, and the same groups as defined for R¹² or R¹⁵; R¹⁴ represents the same groups as defined for R¹¹, R¹³ or R¹⁵; m11 satisfies 0 ≦m11≦1; m12 satisfies 0≦m12≦1; and m13 satisfies 0≦m13≦ 2;
an organic solvent; and
an acid generator.
An antireflection film formed by using the antireflection film composition according to the present invention has an n value and a k value that can exhibit sufficient antireflection effect, particularly when the film is exposed to a short wavelength radiation. The antireflection film has high etch selection ratio to a photoresist film, namely being etched faster than the photoresist film. The antireflection film is a dense inorganic film, whereby an excellent resist pattern can be formed on the overlying photoresist film. The antireflection film can be easily removed with wet stripping. The antireflection film composition contains an acid generator and the acid generator promotes crosslinking. The crosslinking hardens the composition, whereby an obtained antireflection film exhibits excellent dry etching resistance when underlying layer is etched. Accordingly, the antireflection film functions as an etching mask, and the film is suitable for an intermediate resist film of a multilayer resist film. Furthermore, the antireflection film composition according to the present invention shows excellent preservation stability, and a film thickness hardly varies for the long term preservation.

In the above cases, it is preferable that the chelating agent is selected from beta-diketones.

As mentioned above, specific examples of the chelating agent are beta-diketones.

In the above cases, it is preferable that R² in the general formula (1) has a phenyl group.

As mentioned above, a specific example of a light absorbing group of R² is a phenyl group.

In the above cases, it is preferable that R¹² in the general formula (2) has a phenyl group.

As mentioned above, a specific example of a light absorbing group of R¹² is a phenyl group.

Furthermore, the present invention provides a patterning process for patterning a substrate with lithography comprising: at least
forming an organic film (23) over a substrate (22) as a lower resist film;
applying the antireflection film composition according to the present invention over the lower resist film, and baking the composition to form an antireflection film (20) as an intermediate resist film;
applying a photoresist film composition over the intermediate resist film, and prebaking the composition to form a photoresist film (21) as an upper resist film;
exposing a pattern circuit area of the upper resist film and then developing the film with a developer to form a resist pattern on the upper resist film;
etching the intermediate resist film with using the upper resist film on which the resist pattern is formed as a mask;
etching the lower resist film with using the patterned intermediate resist film as a mask; and
etching the substrate (22) with using the lower resist film as a mask.

As mentioned above, an antireflection film according to the present invention is formed over a substrate via an organic film, and has excellent features that the antireflection film functions as an excellent etching mask when the organic film is etched. Therefore, patterning the substrate with lithography as mentioned above provides a fine pattern on the substrate with high accuracy.

In the above case, it is possible that a process layer (22a) of the substrate (22) to be patterned is a low dielectric constant film having a dielectric constant of 3.8 or less.

In this way, a low dielectric constant film can be used as a process layer of the substrate to be patterned. The low dielectric constant films have come to be used to reduce interconnect capacitance as higher integration degree and higher speed of semiconductor integrated circuits have been achieved in recent years.

In the above cases, the intermediate resist film can be removed with wet stripping after being patterned.

In this way, when the intermediate resist film is formed with an antireflection film composition according to the present invention, the intermediate resist film can be removed easily with wet stripping, without using dry etching.

Furthermore, the present invention provides a multilayer resist element comprising at least an organic film, an antireflection film over the organic film, and a photoresist film over the antireflection film, wherein the antireflection film is formed by applying any one of the above antireflection film compositions over the organic film, and baking the composition.

The multilayer resist element having an antireflection film formed by applying any one of the antireflection film compositions according to the present invention over the organic film, and baking the composition has excellent features that a film thickness of the antireflection film hardly varies for the long term preservation, and so on. Therefore, even when the multilayer resist element is patterned after preservation, fine patterns can be formed with high precision.

As described above, use of the antireflection film composition according to the present invention provides an antireflection film with an n value and a k value that can exhibit sufficient antireflection effect, particularly when the film is exposed to a short wavelength radiation. The antireflection film exhibits high etch selection ratio, that is, the antireflection film is etched sufficiently faster than a photoresist film. Furthermore, a resist pattern to be formed on a photoresist film over the antireflection film has almost straight wall profile with hardly generating reverse tapered profile, footing profile, etc. The antireflection film can be easily removed with wet stripping. The antireflection film has excellent preservation stability. Furthermore, the antireflection film shows an excellent etching resistance when an underlying layer is etched, whereby the antireflection film functions as an excellent etching mask. Therefore, the antireflection film is suitable for an intermediate resist film of a multilayer resist film.

### BRIEF DESCRIPTION OF THE DRAWINGS

Fig.1 is an explanatory view of one embodiment of a patterning process according to the present invention. Fig. 1 (a) illustrates a resist pattern after development. Fig. 1 (b) illustrates a pattern transferred to an antireflection film. Fig. 1(c) illustrates a pattern transferred to an organic film. Fig. 1(d) illustrates a pattern after a substrate is subjected to dry etching.
Fig.2 is a graph showing a relationship between a film thickness of an antireflection film and reflectivity.

### DESCRIPTION OF THE INVENTION AND A PREFERRED EMBODIMENT

Hereinafter, embodiments of the present invention will be explained. However, the present invention is not limited thereto.

Properties required for antireflection films include that the antireflection films do not intermix with photoresist films and that low molecule components do not diffuse from the antireflection films to a photoresist film layer (Proc. SPIE Vol. 2195, 225-229 (1994)). In order to prevent the intermixing and the diffusion, spin-coated antireflection films are generally baked for thermally crosslinking the films.

By the way, it is desirable that a resist pattern over the antireflection films or resist lower layer films has straight wall profile without footing profile or undercut profile. This is because footing profile generates a dimension conversion difference after the antireflection film is etched, and undercut profile causes a resist pattern to collapse after development.

Against these issues, it was reported that acid-catalyzed crosslinking successfully reduced footing profile of a positive resist (see Proc. SPIE Vol.3678, 241-250 (1999)). A method of adding crosslinker and inducing acid-catalyzed crosslinking is important for using antireflection film compositions. And it was reported that addition of crosslinker was effective (see Japanese Unexamined Patent Application Publication No. 2001-53068; and U.S. Patent No. 6420088 specification).

Other properties required for antireflection films are that the antireflection films function as hard masks when an underlying layer is processed; and that the antireflection films can be removed after the processing.

In addition, the present inventors considered that omitting a baking step for facilitating wet-stripping of antireflection films which is conducted at the time of wet-stripping would improve production efficiency.

Based on the findings mentioned above, the present inventors examined materials other than silicon and carbon to find a composition that exhibits all the properties mentioned above which conventional compositions cannot exhibit all together. And the inventors found that a polymer or a composition obtained by adding titanium component has lithographic characteristics and sufficiently high etch selection ratio to organic compositions, and can be easily removed with wet stripping. The inventors also found that use of the titanium component as a polymeric form in the polymer or the composition reduced the tendency of the titanium component being lost under heat history in a process for forming a film with the polymer or the composition, whereby optical constant of the film is maintained.

However, titanium component in polymers has strong tendency to condense and thus has characteristics that tend to cause gelation or form aggregate, whereby the polymers have a problem of low preservation stability for practical use. Then the present inventors provide high preservation stability by chelating and thus blocking terminal condensation domain of the polymer or the titanium oxide sol.

Furthermore, the present inventors found the following: When a polymer with crosslinkable groups is used as a polymer according to the present invention and an antireflection film composition containing an acid generator is used as an antireflection film composition according to the present invention, the polymer crosslinks with acid generated from the acid generator and thus hardens, thereby providing an antireflection film that exhibits excellent etching resistance when an underlying layer is etched and that is suitable for an intermediate resist film of a multilayer resist film. Thus, they have accomplished the present invention.

That is, the present invention provides an antireflection film composition for forming an intermediate resist film in a multilayer resist element used in lithography comprising: at least
a polymer obtained by reacting a chelating agent with a polymer having a repeating unit represented by the following general formula (1), 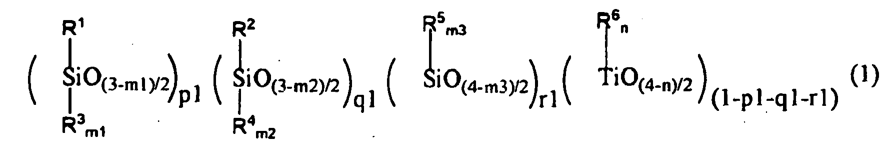 ,wherein R¹ represents a monovalent organic group that reacts with crosslinker and/or any one or more of the organic groups R², R³, R⁴, and R⁶ to form crosslinking; R² represents a monovalent organic group having a light absorbing group; R⁵ represents the same or different group that does not crosslink with crosslinker or organic groups in the formula (1); p1, q1 and r1 satisfy 0<p1<1, 0<ql<1, 0≦r1<1 and 0.5<p1+q1+r1<1; R³ represents any one of a hydroxy group, an alkyl group having 1-6 carbon atoms, an alkoxy group having 1-4 carbon atoms, and the same groups as defined for R² or R⁵; R⁴ represents the same group as R¹, R³ or R⁵; m1 satisfies 0 ≦ m1≦1 ; m2 satisfies 0≦m2≦1 ; m3 satisfies 0≦m3≦2 ; R⁶ independently represents an alkoxy group having 1-6 carbon atoms or a hydroxy group; and n satisfies 0≦n≦3;
an organic solvent; and
an acid generator.

The present invention also provides an antireflection film composition for forming an intermediate resist film in a multilayer resist element used in lithography comprising: at least
a composition obtained by reacting a chelating agent with a composition containing a polymer having a repeating unit represented by the following general formula (2) and titanium oxide sol in the proportions of 100 parts of the polymer to 1-50 parts of the sol, 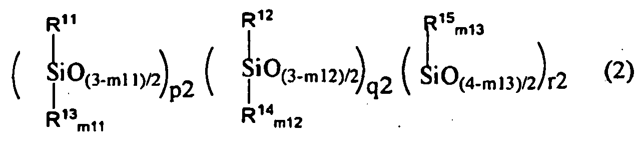 ,wherein R¹¹ represents a monovalent organic group that reacts with crosslinker and/or any one or more of the organic groups R¹², R¹³, R¹⁴ to form crosslinking; R¹² represents a monovalent organic group having a light absorbing group; R¹⁵ represents the same or different group that does not crosslink with crosslinker or organic groups in the formula (2); p2, q2 and r2 satisfy 0<p2<1, 0<q2<1, 0≦r2<1 and 0<p2+q2+r2≦1; R¹³ represents any one of a hydroxy group, an alkyl group having 1-6 carbon atoms, an alkoxy group having 1-4 carbon atoms, and the same groups as defined for R¹² or R¹⁵; R¹⁴ represents the same groups as defined for R¹¹, R¹³ or R¹⁵; m11 satisfies 0 ≦m11≦1; m12 satisfies 0≦m12≦1 ; and m13 satisfies 0≦m13≦ 2;
an organic solvent; and
an acid generator.

As mentioned above, an antireflection film composition according to the present invention has high preservation stability by chelating and thus blocking terminal condensation domains of the polymer or the titanium oxide sol with a chelating agent.

A polymer according to the present invention essentially has a crosslinkable group as R¹ or R¹¹. An antireflection film composition according to the present invention essentially contains an acid generator. Therefore, acid generated from the acid generator promotes crosslinking reaction of the polymer, whereby an antireflection film that exhibits excellent dry etch resistance when an underlying layer is etched is provided. When such an antireflection film is formed as an intermediate resist film of a multilayer resist film, the antireflection film functions as an excellent etching mask for an underlying layer.

Furthermore, an antireflection film composition according to the present invention contains titanium component as a repeating unit or titanium oxide sol. Therefore, obtained polymer or composition shows high etch selection ratio to organic compositions while the polymer or the composition can be easily removed with wet stripping.

In addition, the crosslinking of the polymer almost prevents antireflection films from intermixing with photoresist applied over the antireflection films, and almost prevents low molecule components from diffusing from the antireflection films to overlying photoresist layer. Therefore, a resist pattern over the antireflection films has straight wall profile with almost no footing profile or undercut.

A polymer according to the present invention has a light absorbing group R² or R¹², whereby an antireflection film having an n value and a k value that exhibits sufficient antireflection effect in accordance with a film thickness can be obtained.

The recent tendency to achieve higher integration degree and higher speed of semiconductor integrated circuits requires lower dielectric constant by using interlayer insulator layers to reduce interconnect capacitance. As for such insulator films with lower dielectric constant, low dielectric constant films that can replace conventional silicon oxide films have been examined. Conventional inorganic silicon films formed on such low dielectric constant insulator films cannot be removed selectively because the inorganic silicon films and low dielectric constant insulator films share similar properties. On the other hand, films formed by crosslinking of organic functional groups have high carbon content and low silicon content, and consequently has higher dry etch resistance with CF gases than low dielectric constant insulator films. Furthermore, the organic films show high resistance to wet stripping with acid solutions or basic solutions because carbon-carbon bonding shows low ionicity than Si-O-Si bonding. Therefore, it was difficult to remove the organic films without damaging low dielectric constant insulator films.

However, antireflection films formed with antireflection film compositions according to the present invention can be easily and selectively removed with wet stripping even when the films are formed on low dielectric constant insulator films, therefore only the antireflection films can be removed without damaging underlying low dielectric constant insulator films.

In order to obtain a polymer represented by the general formula (1) according to the present invention, silicon-containing compounds and a titanium compound (monomer a1 to d1) represented by the following general formulae are preferably used.

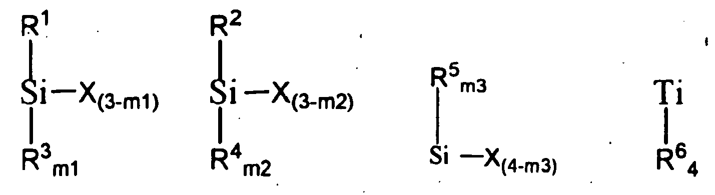

In the formulae, R¹ represents a monovalent organic group that reacts with crosslinker and/or any one or more of organic groups R², R³, R⁴ and R⁶ to form crosslinking; R² represents a monovalent organic group having a light absorbing group; R⁵ represents the same or different group that does not crosslink with crosslinker or organic groups R¹, R², R³, R⁴ and R⁶; R³ represents any one of a hydroxy group, an alkyl group having 1-6 carbon atoms, an alkoxy group having 1-4 carbon atoms, and the same group as R² or R⁵; R⁴ represents the same group as R¹, R³ or R⁵; m1 satisfies 0≦ml≦1; m2 satisfies 0≦m2≦1; m3 satisfies 0≦ m3≦2; R⁶ independently represents an alkoxy group having 1-6 carbon atoms or a hydroxy group; X independently represents any one of a halogen atom, a hydroxy group, and an alkoxy group having 1-6 carbon atoms.

In order to obtain a polymer represented by the general formula (2) according to the present invention, silicon-containing compounds (monomer a2 to c2) represented by the following general formulae are preferably used.

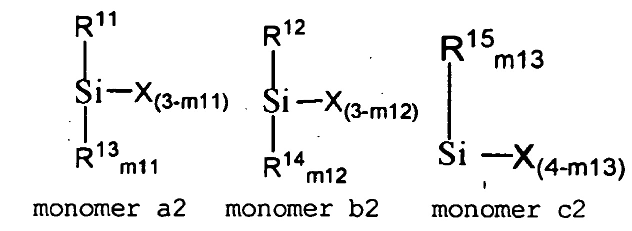

In the formulae, R¹¹ represents a monovalent organic group that reacts with crosslinker and/or any one or more of organic groups R¹², R¹³, and R¹⁴ to form crosslinking; R¹² represents a monovalent organic group having a light absorbing group; R¹⁵ represents the same or different group that does not crosslink with crosslinker or organic groups R¹¹, R¹², R¹³, and R¹⁴; R¹³ represents any one of a hydroxy group, an alkyl group having 1-6 carbon atoms, an alkoxy group having 1-4 carbon atoms, and the same group as R¹² or R¹⁵; R¹⁴ represents the same group as R¹¹, R¹³ or R¹⁵; m11 satisfies 0≦m11≦1 ; m12 satisfies 0≦m12≦1 ; and m13 satisfies 0≦m13≦2 ; X independently represents any one of a halogen atom, a hydroxy group, and an alkoxy group having 1-6 carbon atoms.

In the monomer al, R¹ represents a monovalent organic group that reacts with crosslinker and/or any one or more of organic groups R², R³, R⁴ and R⁶ to form crosslinking. In the monomer a2, R¹¹ represents a monovalent organic group that reacts with crosslinker and/or any one or more of organic groups R¹², R¹³, and R¹⁴ to form crosslinking. In order to react with crosslinker and/or organic groups, R¹ and R¹¹ has, for example, any one or more of a hydroxyl group, an ester group, and an epoxy group. R¹ and R¹¹ preferably have an epoxy group, epoxy groups, a hydroxyl group or hydroxyl groups that highly contribute to hardening of polymers.

Preferred examples of a monovalent organic group of R¹ and R¹¹ are an organic group in which one or more hydrogen atom(s) of a linear, branched or cyclic alkyl group having 1-20 carbon atoms is/are substituted with a hydroxyl group/hydroxyl groups; and an organic group esterified with a carboxylic acid having 4 or less carbon atoms. Specific examples of R¹ and R¹¹ include corresponding organic groups of polymers that are obtained when the following silicon-containing compounds are used as monomers.

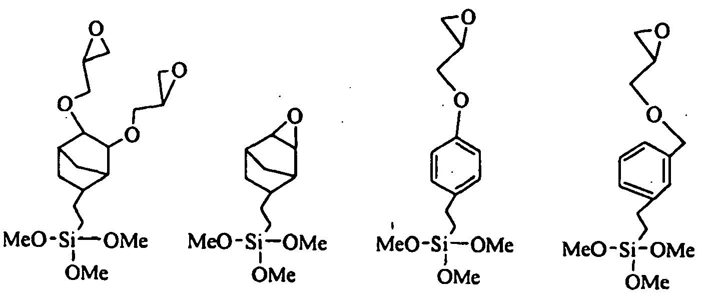

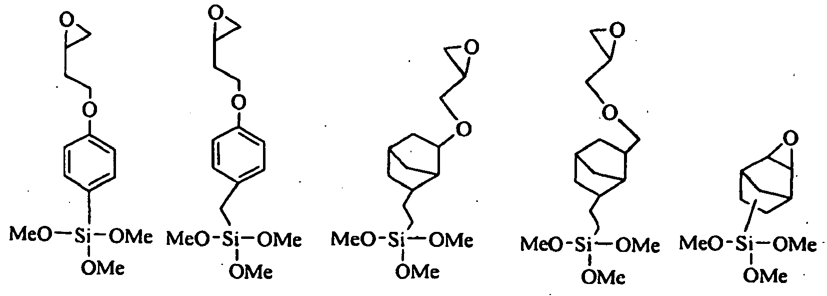

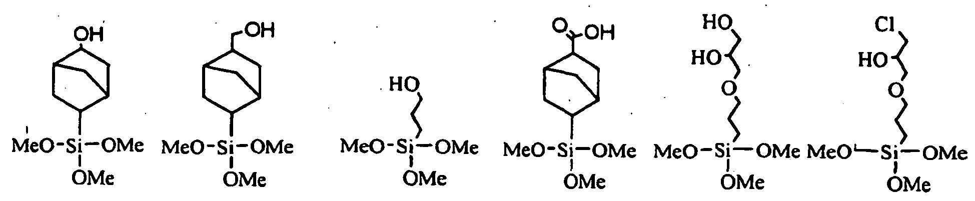

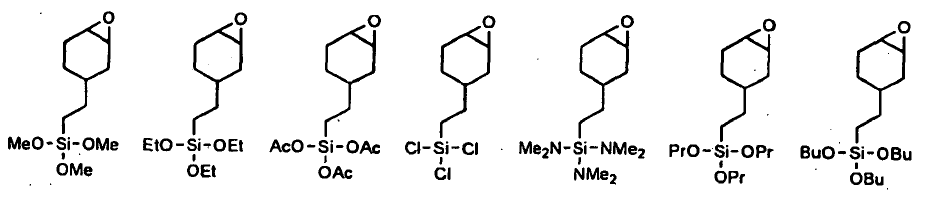

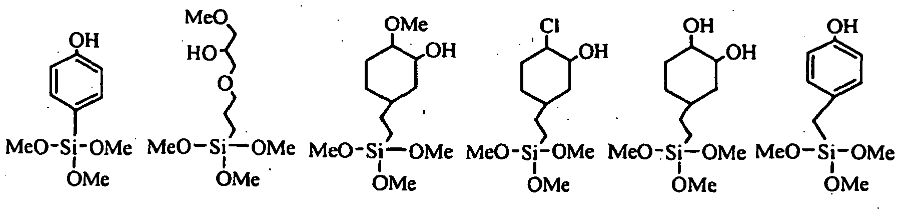

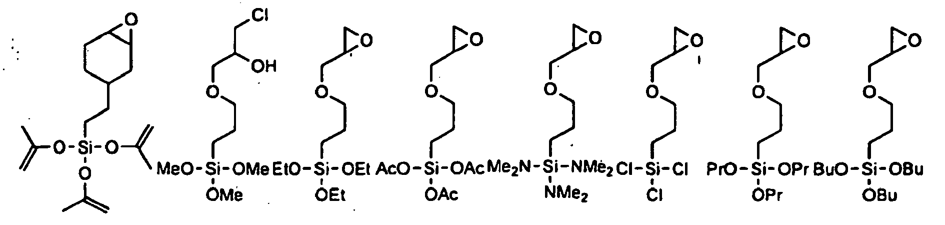

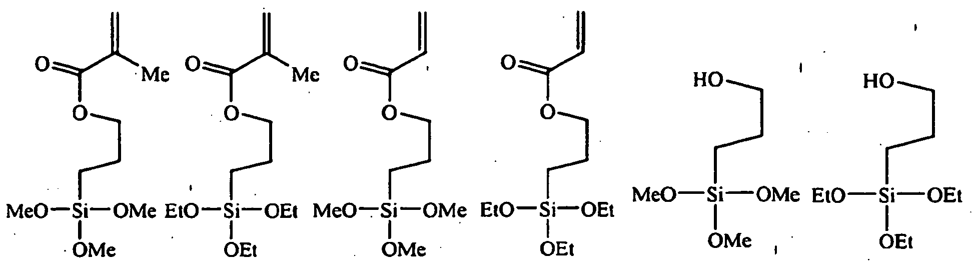

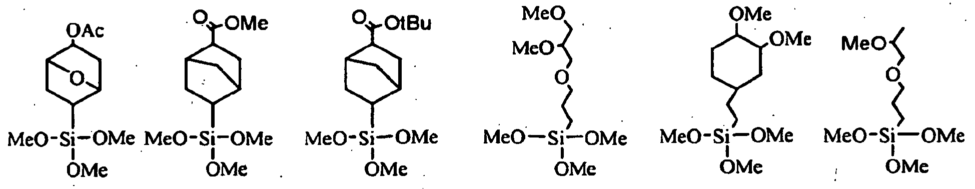

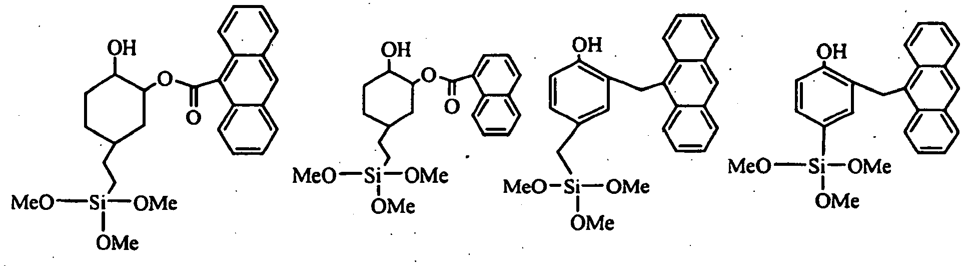

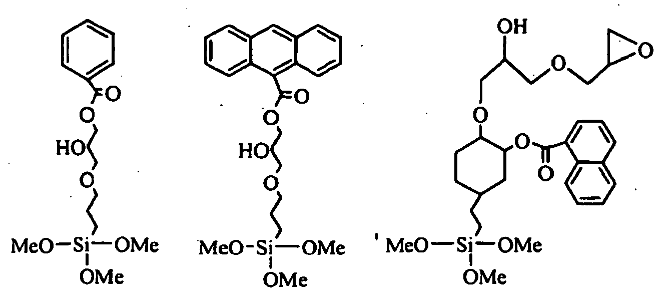

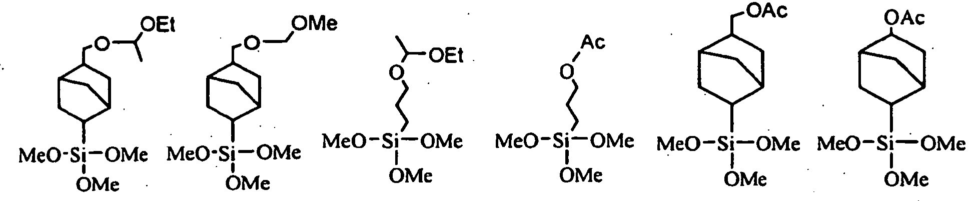

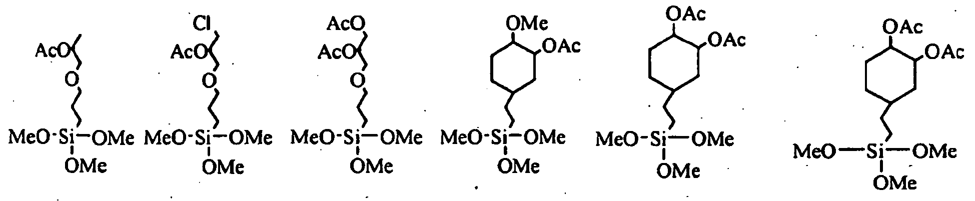

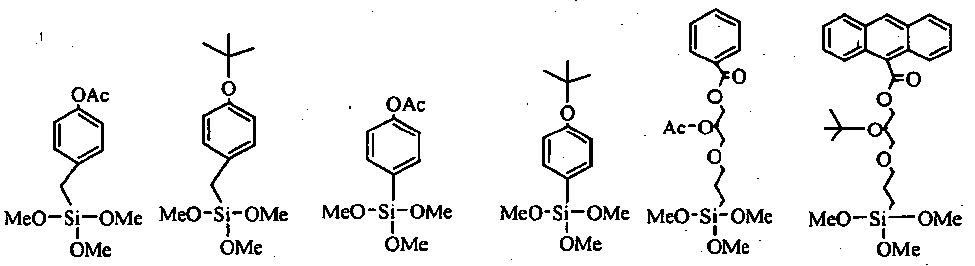

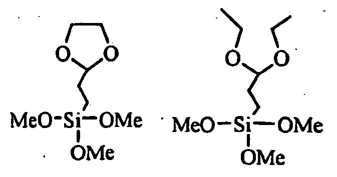

In the formulae, Me represents a methyl group; Et represents an ethyl group; Pr represents a propyl group; Bu represents a butyl group; tBu represents a t-butyl group; and Ac represents an acetyl group.

In the above examples, alkoxy groups, acetoxy groups (CH₃COO-), and acetal groups (C₂H₅OCH(CH₃)O-); t-butoxy group; or t-amyloxy group) can be substituted with hydroxy groups by deprotection during or after polymerization to ensure their reactivity with crosslinkers and/or any one of organic groups R², R³, R⁴ and R⁶ or R¹², R¹³ and R¹⁴ respectively.

R² and R¹² represent a monovalent organic group having a light absorbing group, preferably absorbing radiation in the range of wavelength of 150 to 300 nm; more preferably an anthracene ring, a naphthalene ring, a benzene ring, or one of the rings with one or more substituent(s); and suitably a phenyl group for an intermediate layer composition of ArF resist for micropatterning. Examples of the substituents include an alkoxy group, an acyloxy group and an acetal group having 1 to 6 carbon atoms. Preferred examples of the substituents are methoxy group, t-butoxy group, t-amyloxy group, acetoxy group, 1-ethoxy group, and so on. Specific examples of R² and R¹² include corresponding organic groups of polymers that are obtained when the following silicon-containing compounds are used as monomers.

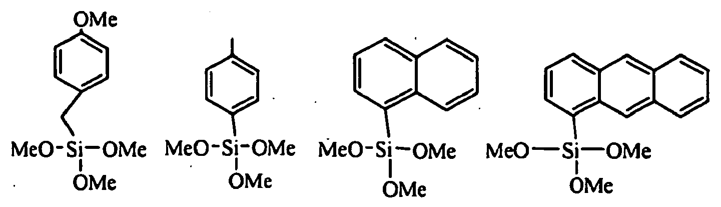

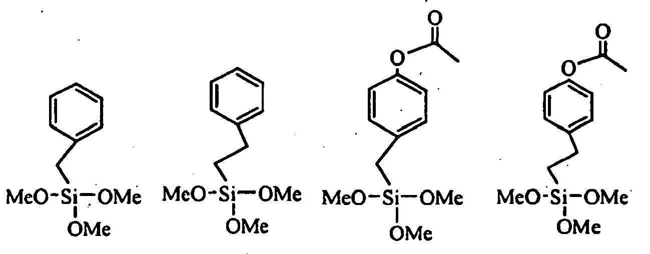

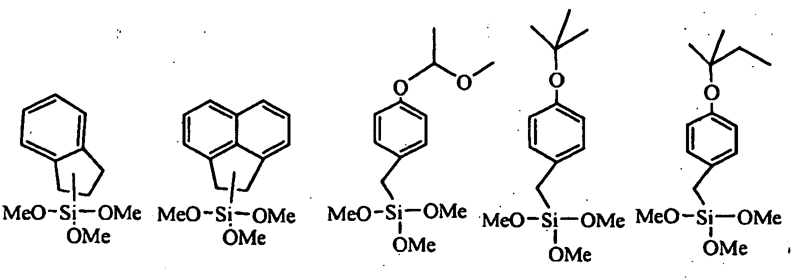

In the formulae, Me represents a methyl group.

In the above examples, alkoxy groups, ester groups (RCOO-), and acetal groups (C₂H₅OCH (CH₃)O-); t- butoxy group; or t-amyloxy group) can be substituted with hydroxy groups by deprotection during or after polymerization.

R⁵ represents a monovalent organic group that does not crosslink with crosslinker or organic groups R¹, R², R³, R⁴ or R⁶ of other monomers. R¹⁵ represents a monovalent organic group that does not crosslink with crosslinker or organic groups R¹¹, R¹², R¹³, or R¹⁴ of other monomers. Examples of R⁵ and R¹⁵ include substituted or unsubstituted hydrocarbon groups, oxyalkyl groups, and carboxyalkyl groups. Specific examples of R⁵ and R¹⁵ include corresponding organic groups of polymers that are obtained when the following silicon-containing compounds are used as monomers.

The compounds include bifunctional silane compounds such as dimethyldichlorosilane, dimethyldimethoxysilane, dimethyldiethoxysilane, dimethyldiacetoxysilane, dimethylbis(dimethylamino)silane, phenylmethyldichlorosilane, phenylmethyldimethoxysilane, phenylmethyldiethoxysilane, phenylmethyldiacetoxysilane, or phenylmethylbis(dimethylamino)silane; and trifunctional silane compounds such as methyltrimethoxysilane, methyltriethoxysilane, methyltrichlorosilane, methyltris(dimethylamino)silane, methyltripropoxysilane, methyltributoxysilane, ethyltrimethoxysilane, ethyltriethoxysilane, ethyltrichlorosilane, ethyltris(dimethylamino)silane, ethyltripropoxysilane, ethyltributoxysilane, propyltrimethoxysilane, propyltriethoxysilane, propyltrichlorosilane, butyltrimethoxysilane, butyltriethoxysilane, butyltrichlorosilane, phenyltrimethoxysilane, naphthyltrimethoxysilane, anthracenylmethyltrimethoxysilane, phenyltriethoxysilane, phenyltrichlorosilane, t-butyltrimethoxysilane, t-butyltriethoxysilane, t-butyltrichlorosilane, neo-pentylbutyltrimethoxysilane, cyclopenthyltrimethoxysilane, cyclohexyltrimethoxysilane, hexyltrimethoxysilane, neo-pentyltriethoxysilane, neopentyltrichlorosilane, 3,3,3-trifluoropropyltrimethoxysilane, 3,3,3-trifluoropropyltriethoxysilane, 3,3,3-trifluoropropyltrichlorosilane, methyldichlorosilane, methyldimethoxysilane, methyldiethoxysilane, methyldiacetoxysilane, or the following compounds.

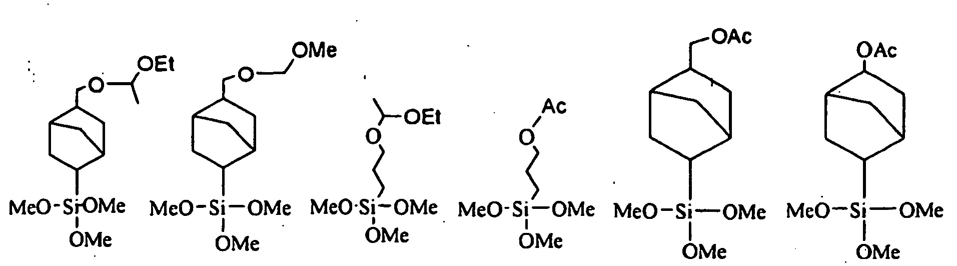

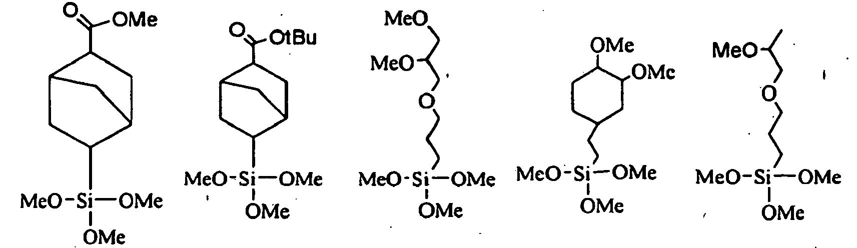

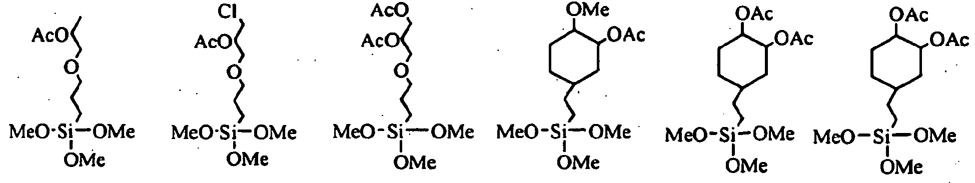

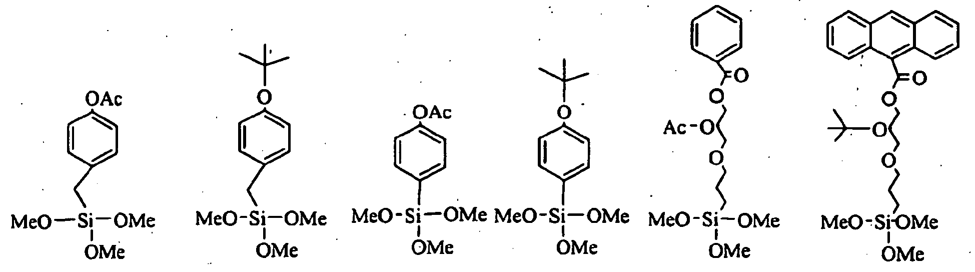

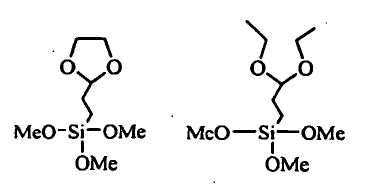

In the formulae, Me represents a methyl group; Et represents an ethyl group; tBu represents a t-butyl group; and Ac represents an acetyl group.

Furthermore, examples of the silicon-containing compounds also include tetrafunctional silane compounds such as tetramethoxysilane, tetraethoxysilane, tetrapropoxysilane, tetrabutoxysilane, or tetraphenoxysilane.

Among the tetrafunctional silane compounds and trifunctional silane compounds, trialkoxymethylsilanes having small organic groups are preferably used because polymers to be obtained have high silicon content, thereby exhibiting high etch ratio to resist films.

In the above examples, alkoxy groups, ester groups (RCOO-), and acetal groups (C₂H₅OCH (CH₃) O-); t- butoxy group; or t-amyloxy group) are not converted to groups that react with crosslinker in antireflection film compositions.

R³ represents any one of a hydroxy group, an alkyl group having 1-6 carbon atoms, an alkoxy group having 1-4 carbon atoms, and the same group as R² or R⁵. R¹³ represents any one of a hydroxy group, an alkyl group having 1-6 carbon atoms, an alkoxy group having 1-4 carbon atoms, and the same group as R¹² or R¹⁵.

R⁴ represents the same group as R¹, R³ or R⁵. R¹⁴ represents the same group as R¹¹, R¹³ or R¹⁵.

R⁶ represents an alkoxy group having 1-6 carbon atoms or a hydroxy group. Examples of R⁶ include corresponding organic groups of polymers that are obtained when the following titanium-containing compounds are used as monomers: titanium methoxide, titanium ethoxide, titanium propoxide, titanium butoxide, titanium-2-ethylhexanoxide, titanium tetrahydrofurfuryloxide, titanium triethanolaminateisopropoxide, t-titanium sulfide, titanium nitrate, quadrivalent hydrolyzable titanium compounds such as titanium tetrachloride, titanium tetrabromide, titanium tetrafluoride, or titanium tetraiodide.

As for titanium oxide sol added to a polymer having a repeating unit represented by the above general formula (2), commercially available titanium oxide sol can be used. Sols with grain size of 10 nm or less that do not cause defects in micropatterns are preferably used.

Mass-average molecular weight (relative to polystyrene standard) of polymers represented by the above general formulae (1) and (2) measured by gel permeation chromatography (GPC) is preferably 1000 to 1,000,000, more preferably 1,000 to 100,000. Molecular weight of 1,000 or more gives polymers sufficient viscosity. Therefore, it is hardly necessary to reduce revolution speed when the polymers are applied with spin-coating, and film thickness variation in a film surface can be reduced sufficiently. Molecular weight of 100,000 or less reduces the possibility that microgel is generated in a film surface when the film is formed, whereby there is little possibility that optical defects are generated.

Next, composition of silanes to be hydrolyzed is explained. Composition of silanes is determined in consideration of balance of 4 properties: light absorption, hardening, etching resistance, and stripping of desired titanium-containing polymer or titanium oxide sol containing composition.

First, the light absorption property is determined based on reflectivity (n value and k value) with a required film thickness. The reflectivity depends to a large degree on molar mass of a light absorbing group per unit mass of solid contents. When the silanes having R² or R¹² as a light absorbing group as mentioned above are used, each composition q1 and q2 preferably falls within the range of 0.1 to 0.4, more preferably 0.15 to 0.3.

The hardening property of intermediate resist films (antireflection films) has an influence on a pattern on a photoresist film which serves as an upper resist film. The more content of crosslinkable organic groups the silanes have, the higher hardening property the silanes have, whereby denser films are obtained. Use of such films reduce the possibility that defects are generated in a pattern on a photoresist film which serves as an upper resist film, whereby an excellent pattern is formed. Furthermore, when underlying inorganic insulator films are etched, there is little possibility to cause the etchback phenomenon or deform patterns on the insulator films because the antireflection films have high etching resistance. In addition, when the antireflection films are removed with wet stripping, sufficiently high selectivity can be obtained.

When composition ratio of silanes having bulky noncrosslinkable organic groups increases, the antireflection films can be removed with mild conditions because crosslinking is not so dense, whereby the removal of the antireflection films hardly damages underlying inorganic insulator films. Furthermore, there is little possibility that etching underlying inorganic insulator films with fluoro gases causes formation of passive fluorocarbon films in the antireflection films and which makes it difficult to remove the antireflection films with wet stripping.

In summary, balance of the properties can be adjusted: for example, a silicone resin with high hardening property is used to improve pattern property of resist films; titanium component is used to adjust wet stripping property; tetrafunctional silanes having high Si content or trifunctional silanes having small noncrosslinkable alkyl groups are added to adjust etching resistance.

In order to satisfy antireflection films properties, lithographic properties of resist films, mask properties when inorganic insulator films are etched, and easy-to-remove property, composition in which mass of silicon atoms in hardened portion is preferably 10 to 40 mass %, more preferably 15 to 35 mass % in hardened portion of the polymers. When the composition is 15 mass % or more, the antireflection films have high etch ratio to resist films, whereby thinner resist films are easily used. On the other hand, when the composition is 35 mass % or less, the antireflection films can be removed selectively even when their underlying layers are silica low dielectric constant insulator films.

Preferred composition of titanium atoms is that mass of titanium atoms is 1 to 10 mass % of mass of hardened portion of the polymers. Titanium atoms of 1 mass % or more provide the polymers with sufficient wet-stripping property. Titanium atoms of 10 mass % or less provide film uniformity.

Optimum amount of crosslinkable groups varies depending on baking temperature and kinds of resist composition, but the amount preferably falls within the range of 1 mmol to 7 mmol per 1 g of solid content. When the amount is 1 mmol or more per 1 g of solid content, there is little possibility to cause footing profile or remaining of pattern residue in resist patterns. When the amount is 7 mmol or less per 1 g of solid content, such antireflection films can be removed easily. Incidentally, for the sake of convenience, the amount of crosslinkable groups represents molar amount of crosslinkable groups in 1 g of solid content when all hydrolysable groups of silane and titanium turn into Si-O-Si, Ti-O-Ti, or Ti-O-Si.

In order to satisfy this condition, though preferable range considerably varies depending on size of side chains of each component silane, when the above-mentioned silanes having R¹ which is an organic group that reacts with crosslinker and an organic group of other monomers are used, composition of the polymer of the general formula (1) preferably falls within the range of p1 : 0.2 to 0.7, and titanium unit: 0.01 to 0.3. The composition of the titanium unit is preferably 0.3 or less because films with excellent uniformity can be obtained. In order to enhance etching resistance, addition of tetrafunctional silanes having high silicon content or trifunctional silanes having small noncrosslinkable alkyl groups is effective. Though preferred range of composition of such silanes considerably varies depending on size of side chains of each component silane as with the silanes having R¹, a composition in which mass of silicon atoms in hardened portion is 15 mass % or more of hardened portion of the polymers is preferable, and r1 preferably falls within the range of 0.3 to 0.6.

As with above, when the above-mentioned silanes having R¹¹ which is an organic group that reacts with crosslinker and an organic group of other monomers are used, composition of the polymer of the general formula (2) preferably falls within the range of p2:0.1 to 0.8, and composition of the titanium oxide sol falls in the proportions of 100 parts of the polymer to 1 to 20 parts of the sol. When the composition of the titanium oxide sol is 20 parts or less, there is little possibility that the titanium oxide sol agglomerates. In order to enhance etching resistance, addition of tetrafunctional silanes having high silicon content or trifunctional silanes having small noncrosslinkable alkyl groups is effective. Though preferred range of composition of such silanes considerably varies depending on size of side chains of each component silane as with the silanes having R¹¹, a composition in which mass of silicon atoms in hardened portion is 20 mass % or more of hardened portion of the polymers is preferable, and the composition preferably falls within the range of r2: 0.3 to 0.7. ..

In order to enhance preservation stability, bonds that do not involve condensation of titanium atoms of titanosiloxane resins or titanium oxide sols are required to be blocked with a chelating agent. As for the chelating agent, any chelating agents that form chelate with quadrivalent titanium atoms can be used. For example, beta-diketones can be used. Specific examples of beta-diketones include: acetylacetone, 2,4-hexanedione, 2,4-heptanedione, 3,5-heptanedione, 2,4-octanedione, 3,5-octanedione, 3,5-nonadione, 5-methyl-2,4-hexanedione, 2,2,6,6-tetramethyl-3,5-heptanedione, 1,1,1,5,5,5-hexafluoro-2,4-heptanedione, and diacetone alcohols. Among these, acetylacetone or diacetone alcohols, which have low molecular weight, are preferably used because low molecular weight chelating agents have little possibility to cause film loss when films are formed.

Along with the blocking using chelating agents, hydrosilyl groups that are directly bonded to silicon atoms of titanosiloxane resins or siloxane resins may be converted to trimethylsilyl groups. Examples of sililation reagent for trimethylsilyl groups may include: trimethylchlorosilane, trimethylmethoxysilane, trimethylethoxysilane, hexamethyldisilazane. Among these, trimethylmethoxysilane is preferably used because byproduct and unreacted compound can be easily removed.

Titanosiloxane resins of the general formula (1) and compositions containing siloxane resins of the general formula (2) and titanium oxide sol may be produced with any method. A specific example of production methods is explained below, however, the present invention is not limited thereto.

First step of the production method is hydrolytic condensation reaction. Hydrolysate can be synthesized by exposing the hydrolyzable silanes or mixture thereof to water to conduct hydrolytic condensation.

Specific examples of hydrolytic condensation catalyst used for synthesizing siloxane resins may include: acid catalysts such as hydrochloric acid, nitric acid, acetic acid, maleic acid, oxalic acid, sulfuric acid, perchloric acid, citric acid, or solid acid; and base catalysts such as ammonia, methylamine, triethylamine, sodium hydroxide, potassium hydroxide, tetramethyl ammonium hydroxide, DBU (1,8-diaza-bicyclo[5,4,0]-7-undecene) or solid base. An amount of the catalyst preferably falls within the range of 0.01 to 100 mole percent to 1 mole of silane. When the amount is 0.01 mole percent or more, sufficient high rate of hydrolytic condensation reaction is achieved. When the amount is 100 mole percent or less, cost advantage is obtained and the catalyst is easily neutralized in subsequent step.

When titanosiloxane resins are synthesized, the same catalysts used for synthesizing siloxane resins may be used. However, the catalysts can be omitted because titanium compounds used as main raw material have ability to conduct hydrolytic condensation. Furthermore, organic solvents can be added as reaction medium as necessary.

Examples of the organic solvent are not restricted, but may include: pentane, hexane, heptane, octane, benzene, toluene, xylene, acetone, methanol, ethanol, buthanol, ethylene glycol monobutyl ether, diethylene glycol monobutyl ether, triethylene glycol monobutyl ether, tetraethylene glycol monobutyl ether, ethylene glycol monohexyl ether, diethylene glycol monohexyl ether, diethylene glycol mono-2-ethylhexyl ether, ethylene glycol monobutyl ether acetate, diethylene glycol monobutyl ether acetate, 2-methoxyethyl acetate, propylene glycol monomethyl ether, propylene glycol monoethyl ether, propylene glycol mono propyl ether, propylene glycol mono butyl ether, dipropylene glycol monomethyl ether, propylene glycol monomethyl ether acetate, propylene glycol monoethyl ether acetate, propylene glycol-1,2-dimethyl ether, propylene glycol diacetate, methyl methoxy acetate, dimethylketone, cyclohexanone, di-isobutyl ketone, ethyl acetate, butyl acetate, 2-methyl propyl acetate, 3-methyl butyl acetate, ethyl lactate, methyl 3-methoxy propionate, cyclopenthyl methyl ether, 4-hydroxy-4-methyl-2-pentanone, 3,5,5-trimethyl-1-hexanol, diethyl ether, dibutyl ether, and THF (tetrahydrofuran).

When titanosiloxane having a repeating unit represented by the general formula (1) is synthesized, the chelating agent may be further added to conduct blocking of terminal domains at synthesis. When a composition containing a polymer having a repeating unit represented by the general formula (2) and titanium oxide sol, hydrolytic condensation reaction is preferably conducted in the presence of titanium oxide sol to obtain uniform composition. In this case, the chelating agent may also be added to conduct blocking of terminal domains at synthesis.

Reaction temperature range of hydrolytic condensation reaction varies depending on composition and concentration of silanes, composition of solvents and catalyst amount. However, homogeneous system is preferably used to conduct the reaction uniformly, and the preferred reaction temperature is higher than freezing point of a reaction solvent, and lower than boiling point of the solvent.

Mass-average molecular weight of a siloxane resin that is a hydrolytic condensation product is preferably 1,000 to 1,000,000, more preferably 1,000 to 10,000. When the molecular weight is 1,000 or more, excellent film formation property is obtained. When the molecular weight is 1,000,000 or less, sufficient solubility and application properties can be obtained.

Furthermore, hydrolytic reaction conditions may be used to conduct protecting group reaction, deprotecting group reaction, decomposition reaction, polymerization reaction, isomerization to convert organic functional groups of silanes to crosslinkable or noncrosslinkable functional groups, or to add a light absorbing group. Examples of the groups to be converted may include: alkyl groups, a silyl group, hydroxyl groups protected with ester groups, hydroxycarbonyl groups, and amino groups. Specific examples of the protecting groups may include: a methyl group, an ethyl group, a propyl group, a butyl group, a t-butyl group, a furfuryl alkyl group, a phenyl group, a benzyl group, a diphenyl methyl group, a methoxy methyl group, an ethoxy methyl group, a propoxy methyl group, a methoxy ethyl group, a 1-ethoxy ethyl group, a 1-methyl-1-methoxy ethyl group, a 1-isopropoxy ethyl group, 3,3,3-trichloroethyl group, a methoxy propyl group, an ethoxy propyl group, a propoxy propyl group, a dimethoxy propyl group, 2,2,2-trichloroethoxymethyl group, 2-(trimethylsilyl) ethoxy methyl group, a tetrahydropyranyl group, a 3-bromo tetrahydropyranyl group, a 4-methoxy tetrahydropyranyl group, a trimethylsilyl group, a triethylsilyl group, an isopropyl dimethylsilyl group, a t-butyl dimethylsilyl group, a t-butyl diphenylsilyl group, a formyl group, an acetyl group, a 3-phenylpropionate group, a 3-benzoylpropionate group, an isobutyrate group, a 4-oxopentanoate group, a pivaloate group, an adamantoate group, a benzoate group, a methoxy carbonyl group, an ethoxy carbonyl group, a 2,2,2-trichloro ethoxy carbonyl group, an isobutyloxycarbonyl group, a benzyl carbonate group. Preferred examples of the light absorbing groups to be added may include compounds having a benzene ring, a naphthalene ring, or an anthracene ring. Specific examples of such compounds are not restricted but may include: phenol, 2-naphthol, 9-methanol anthracene, benzoic acid, naphthoic acid, 9-anthracene carboxylic acid.

Second step of the production method is to remove acid catalysts or base catalysts from the reaction mixture as necessary. First, the catalysts are neutralized to deactivate the catalysts, whereby the condensation reaction is quenched. Arbitrary inorganic/organic acid or base can be used to neutralize the catalysts. Organic acids or organic bases refined for electronic materials are preferably used. Conditions at this time may be used to conduct protecting group reaction, deprotecting group reaction, decomposition reaction, polymerization reaction, isomerization to convert organic functional groups of silanes to crosslinkable or noncrosslinkable functional groups.

Subsequently, water-soluble solvent used as a solvent and hydrolytic by-product(s) are removed from the solution containing silane reaction mixture under low pressure or reduced pressure, whereby the system is converted to a system substantially consisting of titanosiloxane resin, siloxane resin, or siloxane resin, titanium oxide sol, water, and neutralization salt. In this step, an organic solvent that can dissolve polymers may be added before or after the removal. The organic solvent are not restricted, but examples thereof may include: pentane, hexane, heptane, octane, benzene, toluene, xylene, acetone, methanol, ethanol, buthanol, ethylene glycol monobutyl ether, diethylene glycol monobutyl ether, triethylene glycol monobutyl ether, tetraethylene glycol monobutyl ether, ethylene glycol monohexyl ether, diethylene glycol monohexyl ether, diethylene glycol mono-2-ethylhexyl ether, ethylene glycol monobutyl ether acetate, diethylene glycol monobutyl ether acetate, 2-methoxyethyl acetate, propylene glycol monomethyl ether, propylene glycol monoethyl ether, propylene glycol mono propyl ether, propylene glycol mono butyl ether, dipropylene glycol monomethyl ether, propylene glycol monomethyl ether acetate, propylene glycol monoethyl ether acetate, propylene glycol-1,2-dimethyl ether, propylene glycol diacetate, methyl methoxy acetate, dimethylketone, cyclohexanone, di-isobutyl ketone, ethyl acetate, butyl acetate, 2-methyl propyl acetate, 3-methyl butyl acetate, ethyl lactate, methyl 3-methoxy propionate, cyclopenthyl methyl ether, 4-hydroxy-4-methyl-2-pentanone, 3,5,5-trimethyl-1-hexanol, diethyl ether, dibutyl ether, and THF.

At this stage, a chelating agent may be added to a titanosiloxane resin and a composition containing a siloxane resin and titanium oxide sol to conduct blocking of terminal domains.

After the reaction mixture is concentrated as mentioned above, an organic solvent is added to separate a water layer. However, when an organic solvent added before the concentration separates the mixture into an organic layer and a water layer, an organic solvent is added arbitrarily after the concentration. Furthermore, the organic layer after the water layer is separated is preferably washed with water. This operation removes neutralization salt of condensation catalyst, surplus acid or base used for neutralization, metallic ions contaminating the system during the procedures. The organic solvent to be added is not restricted as long as the solvent can separate the water layer. The organic solvent are not restricted, but specific examples thereof may include: pentane, hexane, heptane, octane, benzene, toluene, xylene, acetone, methanol, ethanol, buthanol, ethylene glycol monobutyl ether, diethylene glycol monobutyl ether, triethylene glycol monobutyl ether, tetraethylene glycol monobutyl ether, ethylene glycol monohexyl ether, diethylene glycol monohexyl ether, diethylene glycol mono-2-ethylhexyl ether, ethylene glycol monobutyl ether acetate, diethylene glycol monobutyl ether acetate, 2-methoxyethyl acetate, propylene glycol monomethyl ether, propylene glycol monoethyl ether, propylene glycol mono propyl ether, propylene glycol mono butyl ether, dipropylene glycol monomethyl ether, propylene glycol monomethyl ether acetate, propylene glycol monoethyl ether acetate, propylene glycol-1,2-dimethyl ether, propylene glycol diacetate, methyl methoxy acetate, dimethylketone, cyclohexanone, di-isobutyl ketone, ethyl acetate, butyl acetate, 2-methyl propyl acetate, 3-methyl butyl acetate, ethyl lactate, methyl 3-methoxy propionate, cyclopenthyl methyl ether, 4-hydroxy-4-methyl-2-pentanone, 3,5,5-trimethyl-1-hexanol, diethyl ether, dibutyl ether, and THF. Blocking of terminal domains of the titanosiloxane resin and the composition containing titanium oxide sol with a chelating agent may be conducted before or after the water layer separation. When silylation of the siloxane resin or the titanosiloxane resin is conducted by adding a silylation reagent, the blocking of terminal domains is preferably conducted after the water layer separation. When the blocking is conducted after the water layer separation, chelation and silylation may be conducted separately or simultaneously.

The polymer solution in which the water layer is thus separated can be used without being processed as a material solution of an antireflection film composition. However, solvent of the polymer solution may optionally be removed, or replaced with desired solvent. Furthermore, at this stage, titanium oxide sol may be added to the polymer of the general formula (2) and blocking of terminal domains with a chelating agent may be conducted.

As for organic solvents used for the antireflection film composition according to the present invention, any organic solvents that can dissolve polymers, acid generators, crosslinkers, and other desired additives and has a boiling point of 200 degrees C or less can be used. Examples of such organic solvents are shown in the hydrolysis step, the concentration step, and the washing step. Among the organic solvents, propylene glycol mono propyl ether acetate (PGMEA), ethyl lactate (EL), propylene glycol mono propyl ether (PnP), and mixture thereof are preferably used because these solvents have excellent solubility of acid generators and excellent solubility and stability of polymers.

The organic solvent is preferably used in an amount of 100 to 2,000 parts by mass, more preferably 400 to 1,900 parts by mass, to 100 parts by mass of solid content of a polymer represented by the general formula (1), or a composition containing a polymer represented by the general formula (2) and titanium oxide sol.

In the present invention, an acid generator is required to be added for further promoting crosslinking reaction by heat. Crosslinking hardens antireflection films and enhances etching resistance of the films, also prevents the antireflection films from mixing with resist films, and prevents low molecule components from migrating or diffusing. There are an acid generator which generates acid by pyrolysis and an acid generator which generates acid upon exposure to optical radiation, and either acid generator can be added.

Examples of the acid generator to be used in the present invention are as follows:
i) an onium salt represented by the following general formulae (P1a-1), (P1a-2), (Pla-3) or (P1b),
ii) a diazomethane derivative represented by the following general formula (P2),
iii) a glyoxime derivative represented by the following general formula (P3),
iv) a bis sulfone derivative represented by the following general formula (P4),
v) a sulfonate of an N-hydroxy imide compound represented by the following general formula (P5),
vi) a β-keto sulfonic-acid derivative,
vii) a disulfone derivative,
viii) a nitro benzyl sulfonate derivative, and
ix) a sulfonate derivative.

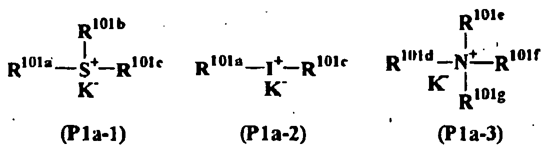

(In the formulae, R^{101a}, R^{101b}, and R^{101c} independently represent a linear, branched or cyclic alkyl group, alkenyl group, oxoalkyl group or oxoalkenyl group each having 1-12 carbon atoms, an aryl group having 6-20 carbon atoms, an aralkyl group or an aryl oxoalkyl group having 7-12 carbon atoms. Some or all of hydrogen atoms of these groups may be substituted with an alkoxy group. R^{101b} and R^{101c} may constitute a ring. In the case that they constitute a ring, R^{101b} and R^{101c} represent an alkylene group having 1-6 carbon atoms respectively. K⁻ represents a non-nucleophilic counter ion. R^{101d}, R^{101e}, R^{101f} and R^{101g} are represented by adding a hydrogen atom to R^{101a}, R^{101b}, and R^{101c}. R^{101d} and R^{101e}, and R^{101d}, R^{101e} and R^{101f} may form a ring respectively. When they form a ring, R^{101d} and R^{101e}, and R^{101d}, R^{101e}, and R^{101f}, represent an alkylene group having 3-10 carbon atoms.)

The above-mentioned R^{101a} , R^{101b}, R^{101c}, R^{101d}, R^{101e}, R^{101f}, and R^{101g} may be the same or different mutually. Examples thereof as an alkyl group may include: a methyl group, an ethyl group, a propyl group, an isopropyl group, n-butyl group, sec-butyl group, tert-butyl group, a pentyl group, a hexyl group, a heptyl group, an octyl group, a cyclopentyl group, a cyclohexyl group, a cycloheptyl group, a cyclopropyl methyl group, 4-methyl cyclohexyl group, a cyclohexyl methyl group, a norbornyl group, and an adamantyl group. Examples of an alkenyl group may include: a vinyl group, an allyl group, a propenyl group, a butenyl group, a hexenyl group, and a cyclohexenyl group. Examples of an oxo alkyl group may include: 2-oxocyclopentyl group, 2-oxocyclohexyl group, 2-oxopropyl group, 2-cyclopentyl-2-oxoethyl group, 2-cyclohexyl-2-oxoethyl group, 2-(4-methylcyclohexyl)-2-oxoethyl group. Examples of an oxoalkenyl group may include: 2-oxo-4-cyclohexenyl group, 2-oxo-4-propenyl group. Examples of an aryl group may include: a phenyl group, a naphthyl group; and an alkoxy phenyl group such as p-methoxyphenyl group, m-methoxyphenyl group, o-methoxyphenyl group, an ethoxyphenyl group, p-tert-butoxyphenyl group, or m-tert-butoxy phenyl group; an alkyl phenyl group such as 2-methylphenyl group, 3-methylphenyl group, 4-methylphenyl group, an ethylphenyl group, 4-tert-butylphenyl group, 4-butylphenyl group, or a dimethyl phenyl group; an alkyl naphthyl group such as a methylnaphthyl group, or an ethyl naphthyl group; an alkoxy naphthyl group such as a methoxy naphthyl group, or an ethoxy naphthyl group; a dialkyl naphthyl group such as a dimethyl naphthyl group, or a diethyl naphthyl group; a dialkoxy naphthyl group such as a dimethoxy naphthyl group, or a diethoxy naphthyl group. Examples of the aralkyl group may include a benzyl group, a phenylethyl group, a phenethyl group. Examples of an aryl oxoalkyl group may include: 2-aryl-2-oxoethyl group such as 2-phenyl-2-oxoethyl group, 2-(1-naphthyl)-2-oxoethyl group, 2-(2-naphthyl)-2-oxoethyl group.

Examples of a non-nucleophilic counter ion as K⁻ may include: a halide ion such as a chloride ion, or a bromide ion; a fluoro alkyl sulfonate such as triflate, 1,1,1-trifluoro ethanesulfonate, or nonafluoro butane sulfonate; an aryl sulfonate such as tosylate, benzene sulfonate, 4-fluorobenzene sulfonate, or 1,2,3,4,5-pentafluoro benzene sulfonate; and an alkyl sulfonate such as mesylate, or butane sulfonate.

While (Pla-1) and (Pla-2) have both effects of a photo acid generator and a thermal acid generator, (Pla-3) acts as a thermal acid generator.

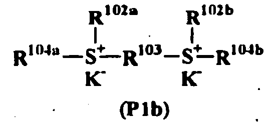

(In the formula, R^{102a} and R^{102b} each represents a linear, branched or cyclic alkyl group having 1-8 carbon atoms. R¹⁰³ represents a linear, branched or cyclic alkylene group having 1-10 carbon atoms. R^{104a} and R^{104b} each represents a 2-oxoalkyl group having 3-7 carbon atoms. K⁻ represents a non-nucleophilic counter ion.)

Examples of the R^{102a} and R^{102b} may include: a methyl group, an ethyl group, a propyl group, an isopropyl group, n-butyl group, sec-butyl group, tert-butyl group, a pentyl group, a hexyl group, a heptyl group, an octyl group, a cyclopentyl group, a cyclohexyl group, a cyclopropylmethyl group, 4-methylcyclohexyl group, a cyclohexyl methyl group.

Examples of R¹⁰³ may include: a methylene group, an ethylene group, a propylene group, a butylene group, a pentylene group, a hexylene group, a heptylene group, an octylene group, a nonylene group, 1,4-cyclohexylene group, 1,2-cyclohexylene group, 1,3-cyclopentylene group, 1,4-cyclooctylene group, 1,4-cyclohexane dimethylene group.

Examples of R^{104a} and R^{104b} may include: 2-oxopropyl group, 2-oxocyclopentyl group, 2-oxocyclohexyl group, 2-oxocycloheptyl group.

Examples of K⁻ may include the same as mentioned in the formulae (P1a-1), (P1a-2) and (P1a-3).

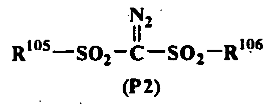

(In the formula, R¹⁰⁵ and R¹⁰⁶ independently represent a linear, branched or cyclic alkyl group or an alkyl halide having 1-12 carbon atoms, an aryl group or an aryl halide having 6-20 carbon atoms, or an aralkyl group having 7-12 carbon atoms.)

Examples of an alkyl group as R¹⁰⁵ and R¹⁰⁶ may include: a methyl group, an ethyl group, a propyl group, an isopropyl group, n-butyl group, sec-butyl group, tert-butyl group, a pentyl group, a hexyl group, a heptyl group, an octyl group, an amyl group, a cyclopentyl group, a cyclohexyl group, a cycloheptyl group, a norbornyl group, an adamantyl group.

Examples of an alkyl halide as R¹⁰⁵ and R¹⁰⁶ may include: trifluoromethyl group, 1,1,1-trifluoroethyl group, 1,1,1-trichloroethyl group, a nonafluoro butyl group. Examples of an aryl group may include: a phenyl group, an alkoxyphenyl group such as p-methoxyphenyl group, m-methoxyphenyl group, o-methoxyphenyl group, an ethoxyphenyl group, p-tert-butoxyphenyl group, m-tert-butoxyphenyl group ; and an alkylphenyl group such as 2-methylphenyl group, 3-methylphenyl group, 4-methylphenyl group, an ethylphenyl group, 4-tert-butylphenyl group, 4-butylphenyl group, a dimethylphenyl group.

Examples of an aryl halide as R¹⁰⁵ and R¹⁰⁶ may include: a fluorophenyl group, a chlorophenyl group, 1,2,3,4,5-pentafluoro phenyl group.

Examples of an aralkyl group as R¹⁰⁵ and R¹⁰⁶ may include: a benzyl group, a phenethyl group.

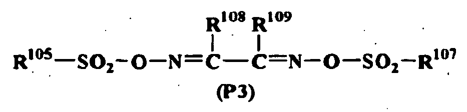

(In the formula, R¹⁰⁷, R¹⁰⁸ and R¹⁰⁹ independently represent a linear, branched, cyclic alkyl group or an alkyl halide having 1-12 carbon atoms, an aryl group or an aryl halide having 6-20 carbon atoms, or an aralkyl group having 7-12 carbon atoms. R¹⁰⁸ and R¹⁰⁹ may be bonded each other to form a cyclic structure. When they form a cyclic structure, R¹⁰⁸ and R¹⁰⁹ each independently represents a linear or branched alkylene group having 1-6 carbon atoms. R¹⁰⁵ represents the same group as mentioned above.)

Examples of the alkyl group, the alkyl halide, the aryl group, the aryl halide, and the aralkyl group as R¹⁰⁷, R¹⁰⁸ and R¹⁰⁹ may be the same as those explained for R¹⁰⁵ and R¹⁰⁶. Examples of an alkylene group for R¹⁰⁸ and R¹⁰⁹ may include: a methylene group, an ethylene group, a propylene group, a butylene group, a hexylene group. 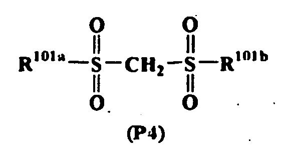 (In the formula, R^{101a} and R^{101b} are the same as explained above.)

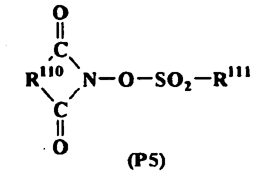

(In the formula, R¹¹⁰ represents an arylene group having 6-10 carbon atoms, an alkylene group having 1-6 carbon atoms or an alkenylene group having 2-6 carbon atoms. Some or all of hydrogen atoms of these groups may be further substituted with a linear or branched alkyl group or an alkoxy group having 1-4 carbon atoms, a nitro group, an acetyl group, or a phenyl group. R¹¹¹ represents a linear, branched or substituted alkyl group, alkenyl group or alkoxy alkyl group having 1-8 carbon atoms, a phenyl group or a naphthyl group. Some or all of hydrogen atoms of these groups may be substituted with an alkyl group or an alkoxy group having 1-4 carbon atoms; a phenyl group which may be substituted with an alkyl group or an alkoxy group having 1-4 carbon atoms, a nitro group or an acetyl group; a hetero aromatic group having 3-5 carbon atoms; or a chlorine atom or a fluorine atom.)

Examples of the arylene group as R¹¹⁰ may include: 1,2-phenylene group, 1,8-naphtylene group. Examples of the alkylene group may include: a methylene group, an ethylene group, a trimethylene group, a tetramethylene group, a phenylethylene group, a norbornane-2,3-di-yl group. Examples of the alkenylene group may include: 1,2-vinylene group, 1-phenyl-1,2-vinylene group, 5-norbornene-2,3-di-yl group.

Examples of the alkyl group as R¹¹¹ may be the same as those for R^{101a} - R^{101c}. Examples of the alkenyl group as R¹¹¹ may include: a vinyl group, a 1-propenyl group, an allyl group, a 1-butenyl group, a 3-butenyl group, an isoprenyl group, a 1-pentenyl group, a 3-pentenyl group, a 4-pentenyl group, a dimethyl allyl group, a 1-hexenyl group, a 3-hexenyl group, a 5-hexenyl group, a 1-heptenyl group, a 3-heptenyl group, a 6-heptenyl group, a 7-octenyl group. Examples of the alkoxy alkyl group may include: a methoxy methyl group, an ethoxy methyl group, a propoxy methyl group, a butoxy methyl group, a pentyloxy methyl group, a hexyloxy methyl group, a heptyloxy methyl group, a methoxy ethyl group, an ethoxy ethyl group, a propoxy ethyl group, a butoxy ethyl group, a pentyloxy ethyl group, a hexyloxy ethyl group, a methoxy propyl group, an ethoxy propyl group, a propoxy propyl group, a butoxy propyl group, a methoxy butyl group, an ethoxy butyl group, a propoxy butyl group, a methoxy pentyl group, an ethoxy pentyl group, a methoxy hexyl group, a methoxy heptyl group.

Examples of the alkyl group having 1-4 carbon atoms which may be further substituted may include: a methyl group, an ethyl group, a propyl group, an isopropyl group, an n-butyl group, an isobutyl group, a tert-butyl group. Examples of the alkoxy group having 1-4 carbon atoms may include: a methoxy group, an ethoxy group, a propoxy group, an isopropoxy group, an n-butoxy group, an isobutoxy group, a tert-butoxy group.

Examples of the phenyl group which may be substituted with an alkyl group and an alkoxy group having 1-4 carbon atoms, a nitro group or an acetyl group may include: a phenyl group, a tolyl group, a p-tert-butoxy phenyl group, a p-acetyl phenyl group, a p-nitrophenyl group. Examples of a hetero aromatic group having 3-5 carbon atoms may include: a pyridyl group, a furyl group.

Examples of an acid generator may include: an onium salt such as tetraethyl ammonium trifluoromethane sulfonate, tetraethyl ammonium nonafluoro butane sulfonate, tetra n-butyl-ammonium nonafluoro butane sulfonate, tetraphenyl ammonium nonafluoro butane sulfonate, tetraethyl ammonium p-toluene sulfonate, diphenyl iodinium trifluoromethane sulfonate, (p-tert-butoxy phenyl) phenyl iodinium trifluoromethane sulfonate, diphenyl iodinium p-toluene sulfonate, (p-tert-butoxy phenyl) phenyl iodinium p-toluene sulfonate, triphenyl sulfonium trifluoromethane sulfonate, (p-tert-butoxy phenyl) diphenyl sulfonium trifluoromethane sulfonate, bis(p-tert-butoxy phenyl) phenyl sulfonium trifluoromethane sulfonate, tris (p-tert-butoxy phenyl) sulfonium trifluoromethane sulfonate, triphenyl sulfonium p-toluene sulfonate, (p-tert-butoxy phenyl) diphenyl sulfonium p-toluene sulfonate, bis(p-tert-butoxy phenyl) phenyl sulfonium p-toluene sulfonate, tris (p-tert-butoxy phenyl) sulfonium p-toluene sulfonate, triphenyl sulfonium nonafluoro butane sulfonate, triphenyl sulfonium butane sulfonate, triethyl sulfonium trifluoromethane sulfonate, trimethyl sulfonium p-toluene sulfonate, cyclohexyl methyl (2-oxocyclohexyl) sulfonium trifluoromethane sulfonate, cyclohexyl methyl (2-oxo cyclohexyl) sulfonium p-toluene sulfonate, dimethyl phenyl sulfonium trifluoromethane sulfonate, dimethyl phenyl sulfonium p-toluene sulfonate, dicyclohexyl phenyl sulfonium trifluoromethane sulfonate, dicyclohexyl phenyl sulfonium p-toluene sulfonate, trinaphthylsulfonium trifluoromethane sulfonate, cyclohexylmethyl (2-oxocyclohexyl) sulfonium trifluoromethane sulfonate, (2-norbonyl) methyl (2-oxocyclohexyl) sulfonium trifluoromethane sulfonate, ethylene bis [methyl (2-oxocyclopentyl) sulfonium trifluoromethane sulfonate], 1,2'-naphthyl carbonyl methyltetrahydro thiophenium triflate.

Examples of a diazomethane derivative may include: bis(benzene sulfonyl) diazomethane, bis(p-toluene sulfonyl) diazomethane, bis(xylene sulfonyl) diazomethane, bis(cyclohexyl sulfonyl) diazomethane, bis(cyclopentyl sulfonyl) diazomethane, bis(n-butylsulfonyl) diazomethane, bis(isobutyl sulfonyl) diazomethane, bis(sec-butylsulfonyl) diazomethane, bis(n-propylsulfonyl) diazomethane, bis(isopropyl sulfonyl) diazomethane, bis(tert-butylsulfonyl) diazomethane, bis(n-amylsulfonyl) diazomethane, bis(isoamylsulfonyl) diazomethane, bis(sec-amylsulfonyl) diazomethane, bis(tert-amylsulfonyl) diazomethane, 1-cyclohexylsulfonyl-1-(tert-butyl-sulfonyl) diazomethane, 1-cyclohexyl sulfonyl-1-(tert-amyl sulfonyl) diazomethane, 1-tert-amyl sulfonyl-1-(tert-butyl-sulfonyl) diazomethane.

Examples of a glyoxime derivative may include: bis-O-(p-toluene sulfonyl)-α-dimethylglyoxime, bis-O-(p-toluene sulfonyl)-α-diphenyl glyoxime, bis-O-(p-toluene sulfonyl)-α-dicyclohexyl glyoxime, bis-O-(p-toluene sulfonyl)-2,3-pentanedione glyoxime, bis-O-(p-toluene sulfonyl)-2-methyl-3,4-pentanedione glyoxime, bis-O-(n-butane sulfonyl)-α-dimethylglyoxime, bis-O-(n-butane sulfonyl)-α-diphenyl glyoxime, bis-O-(n-butane sulfonyl)-α-dicyclohexyl glyoxime, bis-O-(n-butane sulfonyl)-2,3-pentanedione glyoxime, bis-O-(n-butane sulfonyl)-2-methyl-3,4-pentanedione glyoxime, bis-O-(methane sulfonyl)-α-dimethylglyoxime, bis-O-(trifluoromethane sulfonyl)-α-dimethylglyoxime, bis-O-(1,1,1-trifluoro ethane sulfonyl)-α-dimethylglyoxime, bis-O-(tert-butane sulfonyl)-α-dimethylglyoxime, bis-O-(perfluoro octane sulfonyl)-α-dimethylglyoxime, bis-O-(cyclohexane sulfonyl)-α-dimethylglyoxime, bis-O-(benzene sulfonyl)-α-dimethylglyoxime, bis-O-(p-fluorobenzene sulfonyl)-α-dimethylglyoxime, bis-O-(p-tert-butylbenzene sulfonyl)-α-dimethylglyoxime, bis-O-(xylene sulfonyl)-α-dimethylglyoxime, bis-O-(camphor sulfonyl)-α-dimethylglyoxime.

Examples of a bissulfone derivative may include: bis naphthyl sulfonyl methane, bis-trifluoro methyl sulfonyl methane, bis methyl sulfonyl methane, bis ethyl sulfonyl methane, bis propyl sulfonyl methane, bis isopropyl sulfonyl methane, bis-p-toluene sulfonyl methane, bis benzene sulfonyl methane.

Examples of the β-ketosulfone derivative may include: 2-cyclohexyl carbonyl-2-(p-toluene sulfonyl) propane, 2-isopropyl carbonyl-2-(p-toluene sulfonyl) propane.

Examples of the nitro benzyl sulfonate derivative may include: 2,6-dinitro benzyl p-toluenesulfonate, 2,4-dinitro benzyl p-toluenesulfonate.

Examples of the sulfonate derivative may include: 1,2,3-tris(methane sulfonyloxy) benzene, 1,2,3-tris(trifluoromethane sulfonyloxy) benzene, 1,2,3-tris(p-toluene sulfonyloxy) benzene.

Examples of the sulfonate derivative of N-hydroxy imide compound may include: N-hydroxy succinimide methane sulfonate, N-hydroxy succinimide trifluoromethane sulfonate, N-hydroxy succinimide ethane sulfonate, N-hydroxy succinimide 1-propane sulfonate, N-hydroxy succinimide 2-propane sulfonate, N-hydroxy succinimide 1-pentane sulfonate, N-hydroxy succinimide 1-octane sulfonate, N-hydroxy succinimide p-toluenesulfonate, N-hydroxy succinimide p-methoxybenzene sulfonate, N-hydroxy succinimide 2-chloroethane sulfonate, N-hydroxy succinimide benzenesulfonate, N-hydroxy succinimide-2,4,6-trimethyl benzene sulfonate, N-hydroxy succinimide 1-naphthalene sulfonate, N-hydroxy succinimide 2-naphthalene sulfonate, N-hydroxy-2-phenyl succinimide methane sulfonate, N-hydroxy maleimide methane sulfonate, N-hydroxy maleimide ethane sulfonate, N-hydroxy-2-phenyl maleimide methane sulfonate, N-hydroxy glutarimide methane sulfonate, N-hydroxy glutarimide benzenesulfonate, N-hydroxy phthalimide methane sulfonate, N-hydroxy phthalimide benzenesulfonate, N-hydroxy phthalimide trifluoromethane sulfonate, N-hydroxy phthalimide p-toluenesulfonate, N-hydroxy naphthalimide methane sulfonate, N-hydroxy naphthalimide benzenesulfonate, N-hydroxy-5-norbornene-2,3-dicarboxyimide methane sulfonate, N-hydroxy-5-norbornene-2, 3-dicarboxyimide trifluoromethane sulfonate, N-hydroxy-5-norbornene-2,3-dicarboxyimide p-toluenesulfonate.

Suitable examples thereof may include: an onium salt such as triphenyl sulfonium trifluoromethane sulfonate, (p-tert-butoxy phenyl) diphenyl sulfonium trifluoromethane sulfonate, tris (p-tert-butoxy phenyl) sulfonium trifluoromethane sulfonate, triphenyl sulfonium p-toluene sulfonate, (p-tert-butoxy phenyl) diphenyl sulfonium p-toluene sulfonate, tris (p-tert-butoxy phenyl) sulfonium p-toluene sulfonate, trinaphthylsulfonium trifluoromethane sulfonate, cyclohexyl methyl (2-oxocyclohexyl) sulfonium trifluoromethane sulfonate, (2-norbonyl)methyl (2-oxocyclohexyl) sulfonium trifluoromethane sulfonate, 1,2'-naphthyl carbonylmethyl tetrahydrothiophenium triflate;
a diazomethane derivative such as bis(benzene sulfonyl) diazomethane, bis(p-toluene sulfonyl) diazomethane, bis(cyclohexyl sulfonyl) diazomethane, bis(n-butylsulfonyl) diazomethane, bis(isobutyl sulfonyl) diazomethane, bis(sec-butylsulfonyl) diazomethane, bis(n-propyl sulfonyl) diazomethane, bis(isopropyl sulfonyl) diazomethane, bis(tert-butylsulfonyl) diazomethane;
a glyoxime derivative, such as bis-O-(p-toluene sulfonyl)-α-dimethylglyoxime, bis-O-(n-butane sulfonyl)-α-dimethylglyoxime;
a bissulfone derivative, such as bisnaphthyl sulfonyl methane;
a sulfonate derivative of N-hydroxyimide compounds, such as N-hydroxy succinimide methane sulfonate, N-hydroxy succinimide trifluoromethane sulfonate, N-hydroxy succinimide 1-propane sulfonate, N-hydroxy succinimide 2-propane sulfonate, N-hydroxy succinimide 1-pentane sulfonate, N-hydroxy succinimide p-toluene sulfonate, N-hydroxy naphthalimide methane sulfonate, N-hydroxy naphthalimide benzene sulfonate.

Incidentally, the acid generator may be used alone or in admixture.

An amount of the acid generator to be added is preferably 0.1 to 50 parts, more preferably 0.5 to 40 parts per 100 parts of a titanosiloxane resin, a polymer or a composition obtained by reacting a chelating agent with a composition containing a siloxane resin and titanium oxide sol. When 0.1 parts or more of the acid generator is added, sufficient amount of acid is generated and a crosslinking reaction is induced sufficiently. On the other hand, when 50 parts or less of the acid generator is added, there is less possibility that mixing phenomenon in which acid migrates to the upper resist layer occurs.

In the antireflection film composition according to the present invention, crosslinks are formed between crosslinkable groups bonded to polymers when an antireflection film is formed. These crosslinks may be formed by direct reaction between the crosslinkable groups bonded to polymers, or by crosslinker having functional groups that can react with the crosslinkable groups. Antireflection film compositions in which crosslinks are formed by direct bonds between the crosslinkable groups bonded to polymers without using low molecular crosslinker have little possibility that unreacted crosslinker diffusing from a formed antireflection film layer to a resist film layer can affect pattern profile in forming the resist film in a patterning process. Therefore, temperature conditions. in the step of forming a resist film can be selected with relative freedom. In consideration of this advantage, no crosslinkers except the polymers are preferably used.

By the way, controlling of crosslink density is important in the patterning process according to the present invention. The present invention has an advantage of being easily adaptable to manufacturing control, changes of use conditions. because just changing addition amount of crosslinker to a composition containing crosslinker enables microadjustment of crosslink density. Crosslinker can also be used for final adjustment of a composition that is prepared basically without adding crosslinker.

Examples of the crosslinker which can be used in the present invention may include: a melamine compound, a guanamine compound, a glycol uryl compound or an urea compound substituted with at least one group selected from a methylol group, an alkoxy methyl group and an acyloxy methyl group; an epoxy compound; a thioepoxy compound; an isocyanate compound; an azide compound; a compound including a double bond such as an alkenyl ether group. These crosslinkers may be used as an additive, but they can be introduced into a polymer side chain as a pendant group. Moreover, a compound containing a hydroxy group can also be used as a crosslinker.

Among the above compounds, examples of the epoxy compound may include: tris(2,3-epoxypropyl)isocyanurate, trimethylol methanetriglycidyl ether, trimethylol propane triglycidyl ether, triethylol ethanetriglycidyl ether

Examples of the melamine compound may include:
hexamethylol melamine, hexamethoxy methyl melamine, a compound in which 1-6 methylol groups of hexamethylol melamine are methoxy methylated or a mixture thereof, hexamethoxy ethyl melamine, hexaacyloxy methyl melamine, a compound in which 1-6 methylol groups of hexamethylol melamine are acyloxy methylated or a mixture thereof.

Examples of the guanamine compound may include:
tetramethylol guanamine, tetra methoxy methyl guanamine, a compound in which 1-4 methylol groups of tetramethylol guanamine are methoxy-methylated and a mixture thereof, tetramethoxy ethyl guanamine, tetraacyloxy guanamine, a compound in which 1-4 methylol groups of tetramethylol guanamine are acyloxy-methylated and a mixture thereof.

Examples of the glycol uryl compound may include:
tetramethylol glycol uryl, tetramethoxy glycol uryl, tetramethoxy methyl-glycol uryl, a compound in which 1-4 methylol groups of tetramethylol glycol uryl are methoxy methylated or a mixture thereof, and a compound in which 1-4 methylol group of tetramethylol glycol uryl are acyloxy methylated or a mixture thereof.

Examples of the urea compound may include: tetra methylol urea, tetra methoxy methyl urea, a compound in which 1-4 methylol groups of tetra methylol urea are methoxy-methylated or a mixture thereof, and tetra methoxy ethyl urea.

Examples of the compound containing an alkenyl ether group may include: ethylene glycol divinyl ether, triethylene-glycol divinyl ether, 1,2-propanediol divinyl ether, 1,4-butanediol divinyl ether, tetramethylene-glycol divinyl ether, neo pentyl glycol divinyl ether, trimethylol-propane trivinyl ether, hexane diol divinyl ether, 1,4-cyclohexane diol divinyl ether, pentaerythritol trivinyl ether, pentaerythritol tetra vinyl ether, sorbitol tetra vinyl ether, sorbitol penta vinyl ether, and trimethylol-propane trivinyl ether.

When the polymer has an epoxy group as a crosslinkable group, addition of a compound having a hydroxy group enhances reactivity with the epoxy group and crosslinking efficiency. In particular, compounds having two or more hydroxy groups in a molecule are preferably used. Examples of such compounds may include: alcohol group containing compounds such as 4,8-bis(hydroxymethyl) tricyclo [5.2.1.0^{2,6}]-decane, pentaerythritol, 1,2,6-hexanetriol, 4,4',4''-methylidene tris cyclohexanol, 4,4'-[1-[4-[1-(4-hydroxy cyclohexyl)-1-methylethyl] phenyl] ethylidene] biscyclohexanol, [1,1'-bicyclohexyl]-4,4'-diol, methylene biscyclohexanol, decahydro naphthalene-2,6-diol, or [1,1'-bicyclohexyl]-3,3',4,4'-tetrahydroxy; and pheonls containing less benzene nuclei such as bisphenol, methylene bisphenol, 2,2'-methylene bis [4-methyl phenol], 4,4'-methylidene-bis[2,6-dimethylphenol], 4,4'-(1-methylethylidene) bis [2-methyl phenol], 4,4'-cyclohexylidene bisphenol, 4,4'-(1,3-dimethyl butylidene)bisphenol, 4,4'-(1-methyl-ethylidene) bis [2,6-dimethyl phenol], 4,4'-oxybisphenol, 4,4'-methylene bisphenol, bis(4-hydroxyphenyl) methanone, 4,4'-methylene bis[2-methylphenol], 4,4'-[1,4-phenylene bis(1-methyl ethylidene)] bisphenol, 4,4'-(1,2-ethane-di-yl) bisphenol, 4,4'-(diethyl silylene) bisphenol, 4,4'-[2,2,2-trifluoro-1-(trifluoromethyl) ethylidene] bisphenol, 4,4',4" - methylidene trisphenol, 4,4'-[1-(4-hydroxyphenyl)-1-methylethyl]phenyl]ethylidene] bisphenol, 2,6-bis[(2-hydroxy-5-methylphenyl)methyl]-4-methyl phenol, 4,4',4"-ethylidyne tris[2-methyl phenol], 4,4',4''-ethylidyne trisphenol, 4,6-bis[(4-hydroxy phenyl)methyl]1,3-benzene diol, 4,4'-[(3,4-dihydroxy phenyl)methylene]bis[2-methylphenol], 4,4',4'',4'''-(1, 2-ethanediylidene) tetrakisphenol, 4,4',4",4"'-ethanediylidene tetrakis[2-methylphenol], 2,2'-methylene bis [6-[(2-hydroxy-5-methylphenyl)methyl]-4-methylphenol], 4,4',4",4"'-(1,4-phenylene dimethylidyne) tetrakisphenol, 2,4,6-tris(4-hydroxy phenylmethyl)-1,3-benzenediol, 2,4',4''-methylidene trisphenol, 4,4',4"'-(3-methyl-1-propanyl-3-ylidene) trisphenol, 2,6-bis[(4-hydroxy-3-phlorophenyl) methyl]-4-fluorophenol, 2,6-bis[4-hydroxy-3-fluorophenyl]methyl]-4-fluorophenol, 3,6-bis[(3,5-dimethyl-4-hydroxyphenyl)methyl]1,2-benzenediol, 4,6-bis[(3,5-dimethyl-4-hydroxy phenyl)methyl]1,3-benzenediol, p-methylcalics[4]allene, 2,2'-methylene bis[6-[(2,5/3,6-dimethyl-4/2-hydroxyphenyl)methyl]-4-methylphenol, 2,2'-methylene bis[6-[(3,5-dimethyl-4-hydroxyphenyl) methyl]-4-methyl phenol, 4,4',4'',4'''-tetrakis [(1-methyl ethylidene)bis(1,4-cyclohexylidene)]-phenol, 6,6'-methylene bis [4-(4-hydroxy phenyl methyl)-1,2,3-benzentriol, or 3,3',5,5'-tetrakis [(5-methyl-2-hydroxyphenyl)methyl]-[(1,1'-biphenyl)-4,4'-diol].

In the present invention, a bulking agent may optionally be added to enhance solubility in a stripping solution. In order to achieve the same object, a pyrolytic bulking agent (porogen) may also be added to introduce pores into a crosslinked film of a titanosiloxane resin or a siloxane resin by applying a composition, forming a crosslinked film with crosslinking reaction, and subsequently baking the film. This baking step may be conducted concurrently with crosslinking of a titanosiloxane resin or a siloxane resin, but also conducted immediately before a step of removing a crosslinked film of a titanosiloxane resin or a siloxane resin. Preferred bulking agents or porogens that can be used in the above cases are organic polymers that have low reactivity with the titanosiloxane resin or the siloxane resin. Specific examples of the bulking agents or the porogens may include: polyether, acrylic resin, methacrylic resin, POSS (Polyhedral oligomeric silsesquioxane).

By the way, the present invention provides a patterning process for patterning a substrate with lithography comprising: at least
forming an organic film (23) over a substrate (22) as a lower resist film;
applying the antireflection film composition according to the present invention over the lower resist film, and baking the composition to form an antireflection film (20) as an intermediate resist film;
applying a photoresist film composition over the intermediate resist film, and prebaking the composition to form a photoresist film (21) as an upper resist film;
exposing a pattern circuit area of the upper resist film and then developing the film with a developer to form a resist pattern on the upper resist film;
etching the intermediate resist film with using the upper resist film on which the resist pattern is formed as a mask;
etching the lower resist film with using the patterned intermediate resist film as a mask; and
etching the substrate (22) with using the lower resist film as a mask.

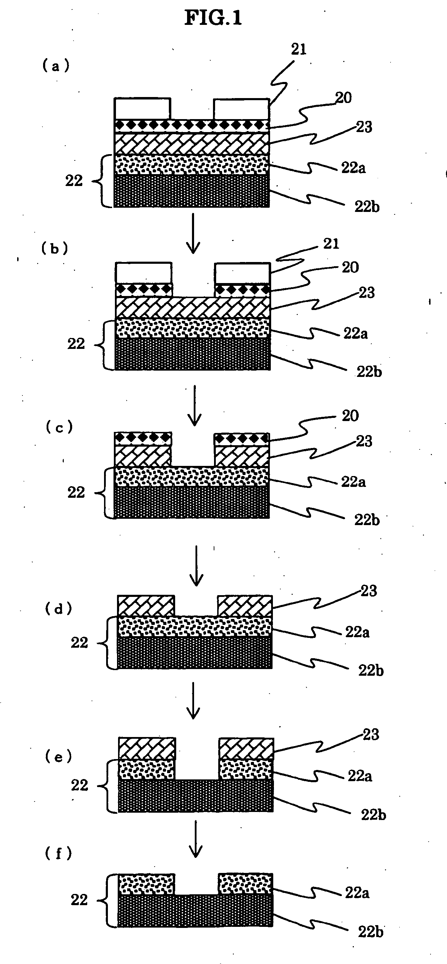

Thus-formed antireflection film made from an antireflection film composition according to the present invention is used as an intermediate layer of a multilayer resist process such as a trilayer resist process. A patterning process using the intermediate layer will be explained in reference to Fig. 1.

First, up to forming a resist pattern as shown in Fig.1 (a) will be explained.

An organic film 23 is formed on a substrate 22 as a lower resist film by spin coating method. The organic film 23 is preferably crosslinked with heat or acid after application by spin coating method. This is because the organic film 23 functions as a mask when the substrate 22 is etched, the film 23 preferably has high etching resistance and is required not to mix with an overlying antireflection film 20.

On the organic film 23 is formed the antireflection film 20 made from the antireflection film composition according to the present invention as an intermediate resist film. Specifically, after applying the antireflection film composition according to the present invention to the organic film 23 by spin-coating, an organic solvent is evaporated, and baking is preferably carried out in order to promote crosslinking reaction to prevent the antireflection film 20 from intermixing with an overlying photoresist film 21. The baking is preferably carried out at a temperature in the range of 80 to 300 degrees C, for 10 to 300 seconds.

After the antireflection film 20 is formed, the photoresist film 21 is formed thereon as an upper resist film. Spin coating method is also preferably used for forming the film 21 as with forming the antireflection film 20. After photoresist film composition is applied by spin-coating method, pre-baking is carried out, preferably at a temperature of 80 to 180 degrees C for 10 to 300 seconds.

After that, a pattern circuit area is exposed, and post exposure baking (PEB) and development with a developer are carried out to obtain a resist pattern (see Fig. 1 (a)).

Examples of a resin for forming the organic film may include: cresol-novolac, naphthol-novolac, naphtholdicyclopentadien-novolac, amorphous carbon, polyhydroxystyrene, acrylate, methacrylate, polyimide, and polysulfone.

Then as shown in Fig. 1(b), the antireflection film 20 is etched with using the patterned photoresist film 21 as a mask to transfer the resist pattern to the antireflection film 20. In order to etch the antireflection film 20 with using the photoresist film 21 as a mask, etching is conducted by using flon gases, nitrogen gas, or carbon dioxide gas. The antireflection film 20 made from the antireflection film composition according to the present invention has a feature that the antireflection film is etched rapidly by the gases and thus film loss of the overlying photoresist film 21 is small.

Next, as shown in Fig. 1(c), the pattern formed on the antireflection film 20 is transferred to the organic film 23 by oxygen plasma etching. At this time, the photoresist film 21 is also etched and removed. The antireflection film 20 made from the antireflection film composition according to the present invention can be used as an etching mask while the organic film is etched because the antireflection film exhibits excellent dry etching resistance under etching conditions for etching the organic film.

Then as shown in Fig. 1(d), the antireflection film 20 is removed with wet stripping, and only pattern-transferred organic film 23 is left on the substrate 22.

Removing the antireflection film with wet stripping as mentioned above gives less damage to a process layer than removing the antireflection film concurrently with dry etching the process layer. Therefore, a pattern with high precision can be obtained. In particular, when the process layer is a porous film such as a silicon-containing low dielectric constant film, removing the antireflection film with wet stripping is effective to obtain a pattern with high precision.

Next, as shown in Fig. 1(e), a process layer 22a on a base layer 22b is subjected to dry etching with using the pattern-transferred organic film 23 as a mask.

After that, as shown in Fig. 1(f), the organic film 23 that remains on the process layer 22a is removed by dry etching to obtain a patterned substrate 22.

A thickness of each film are, for example, 50 to 2000 nm for the organic film 23, 10 to 2000 nm for the antireflection film 20, and 0.1 to 1 µm (preferably 100 to 500 nm) for the photoresist film 21. However, each thickness is not limited thereto.

The substrate to be used for the patterning is not particularly limited and silicon wafers and so on can be used.

By the way, generally known photoresist film compositions can be used for forming the photoresist film. For example, a base resin, an organic solvent, and an acid generator may be combined and used as the composition.

Examples of the base resin may include one or more polymer(s) selected from the group: polyhydroxystyrene and its derivatives; polyacrylic acid and its derivatives; polymethacrylic acid and its derivatives; copolymer synthesized with selecting monomers from hydroxystyrene, acrylic acid and derivatives thereof; copolymer synthesized with selecting three or more monomers from cycloolefin and its derivatives, maleic anhydride, and acrylic acid and its derivatives; copolymer synthesized with selecting three or more monomers from cycloolefin and its derivatives, maleimide, and acrylic acid and its derivatives; polynorbornene; and ring-opening metathesis polymer. Incidentally, the derivatives as mentioned above each has its original main skeleton after being derived. For example, acrylic acid derivatives include acrylate, methacrylic acid derivatives include methacrylate, and hydroxystyrene derivatives include alkoxystyrene.

As for the organic solvent and the acid generator for resist film compositions, the above-mentioned organic solvents and acid generators for the antireflection film composition according to the present invention can be used. As for an addition amount of each component in a resist film composition, for example, an addition amount of the base resin is as with an addition amount of silicone resin in the antireflection film composition; and an addition amount of the organic solvent and the acid generator for resist film compositions is as with an addition amount of the organic solvent and the acid generator for the antireflection film composition.

Furthermore, in the patterning process, the intermediate resist film (the antireflection film 20) may be removed with wet stripping after being patterned. Antireflection films made from the antireflection film composition according to the present invention can be easily removed with wet stripping.

Cases for using wet stripping are not particularly restricted. For example, when the pattern circuit area of the photoresist film 21 is exposed to high energy beams such as ArF or Deep UV, the high energy beams can damage the antireflection film 20 under the photoresist film 21. In this case, the patterning process is conducted again after conducting rework process: the photoresist film 21 and the antireflection film 20 are removed, and a photoresist film 21 and an antireflection film 20 are formed again. As mentioned above, because antireflection films made from the antireflection film composition according to the present invention can be easily removed with wet stripping. Therefore, the rework process can be conducted easily: for example, the photoresist film 21 and the antireflection film 20 can be removed together with wet stripping to enhance efficiency.

Wet stripping solutions are not particularly restricted, and commonly used ones can be used. For example, stripping solutions containing hydrofluoric acid or amines can be used.

In addition, as shown in Fig. 1, the substrate 22 may consist of a base layer 22b and a process layer 22a. The base layer 22b of the substrate 22 is not limited but may be Si, α-Si, p-Si, SiO₂, SiN, SiON, W, TiN, Al, and a different material from a process layer (a substrate to be processed) 22a may be used. As the process layer 22a, Si, SiO₂, SiON, SiN, p-Si, α-Si, W, W-Si, Al, Cu, Al-Si, various low dielectric constant films, and an etching stopper film thereof may be used, and it may be formed generally at a thickness of 50 to 10,000 nm, especially at a thickness of 100 to 5,000 nm.

Incidentally, the low dielectric constant films have a dielectric constant of 3.8 of silicon dioxide (SiO₂) or less.

Furthermore, the present invention provides a substrate comprising at least an organic film, an antireflection film over the organic film, and a photoresist film over the antireflection film, wherein the antireflection film is formed by applying the antireflection film composition according to the present invention over the organic film, and baking the composition.

The antireflection film composition according to the present invention shows excellent preservation stability and a film thickness varies only to a small degree after the long term preservation. Therefore, the substrate has features: fine patterns can be formed with high precision even when the substrate is patterned after preservation.

### EXAMPLE

Hereinafter, the present invention will be explained further in detail with reference to Production Examples, Examples and Comparative Examples. However, the present invention is not limited thereto.

### (Production Example 1)

In a 1 liter flask, 57.2 g of 3,4-epoxycyclohexyl ethyl trimethoxy silane, 11.8 g of phenyl trimethoxy silane, 4.4 g of titanium propoxide, and 200 g of ethanol were placed. And 16.9 g of ultra pure water was added thereto. This solution was stirred at 60 degrees C for an hour, and then 30 g of acetylacetone and 300 g of propylene glycol monomethyl ether acetate were added thereto. The solution was stirred for 2 hours at 100 degrees C with evaporation. Then the solution was concentrated under a reduced pressure (10 hPa) to obtain a 234 g solution of polymer 1. Among the solution, solid contents were 60.1 g.

### (Production Example 2)

In a 1 liter flask, 49.2 g of 3,4-epoxycyclohexyl ethyl trimethoxy silane, 11.8 g of phenyl trimethoxy silane, 24.6 g of titanium propoxide, and 200 g of ethanol were placed. And 20.2 g of ultra pure water was added thereto. This solution was stirred at 60 degrees C for an hour, and then 30 g of acetylacetone and 300 g of propylene glycol monomethyl ether acetate were added thereto. The solution was stirred for 2 hours at 100 degrees C with evaporation. Then the solution was concentrated under a reduced pressure (10 hPa) to obtain a 252 g solution of polymer 2. Among the solution, solid contents were 67.4 g.

### (Production Example 3)

In a 1 liter flask, 29.3 g of 3,4-epoxycyclohexyl ethyl trimethoxy silane, 11.6 g of phenyl trimethoxy silane, 75.7 g of titanium propoxide, and 200 g of ethanol were placed. And 28.8 g of ultra pure water was added thereto. This solution was stirred at 60 degrees C for an hour, and then 30 g of acetylacetone and 300 g of propylene glycol monomethyl ether acetate were added thereto. The solution was stirred for 2 hours at 100 degrees C with evaporation. Then the solution was concentrated under a reduced pressure (10 hPa) to obtain a 288 g solution of polymer 3. Among the solution, solid contents were 85.0 g.

### (Production Example 4)

In a 1 liter flask, 27.8 g of 3,4-epoxycyclohexyl ethyl trimethoxy silane, 11.7 g of phenyl trimethoxy silane, 21.0 g of titanium propoxide, 33.5 g of methyltrimethoxy silane, and 200 g of ethanol were placed. And 27.9 g of ultra pure water was added thereto. This solution was stirred at 60 degrees C for an hour, and then 30 g of acetylacetone and 300 g of propylene glycol monomethyl ether acetate were added thereto. The solution was stirred for 2 hours at 100 degrees C with evaporation. Then the solution was concentrated under a reduced pressure (10 hPa) to obtain a 240 g solution of polymer 4. Among the solution, solid contents were 63.4 g.

### (Production Example 5)

In a 1 liter flask, 29.4 g of 3,4-epoxycyclohexyl ethyl trimethoxy silane, 11.6 g of phenyl trimethoxy silane, 21.6 g of titanium propoxide, 52.9 g of tetraethoxy silane, and 200 g of ethanol were placed. And 33.4 g of ultra pure water was added thereto. This solution was stirred at 60 degrees C for an hour, and then 30 g of acetylacetone and 300 g of propylene glycol monomethyl ether acetate were added thereto. The solution was stirred for 2 hours at 100 degrees C with evaporation. Then the solution was concentrated under a reduced pressure (10 hPa) to obtain a 280 g solution of polymer 5. Among the solution, solid contents were 63.5 g.

### (Production Example 6)

In a 1 liter flask, 57.2 g of 3,4-epoxycyclohexyl ethyl trimethoxy silane, 11.8 g of phenyl trimethoxy silane, 4.4 g of titanium propoxide, and 200 g of ethanol were placed. And 16.9 g of ultra pure water was added thereto. This solution was stirred at 60 degrees C for an hour, and then 300 g of propylene glycol monomethyl ether acetate was added thereto. The solution was stirred at 100 degrees C for 2 hours with evaporation. Then to this solution were added 200 g of trimethylmethoxy silane and 200 g of methanol at 25 degrees C, and stirred for 24 hours. After that, the solution was concentrated under a reduced pressure (10 hPa) to obtain a 220 g solution of polymer 6. Among the solution, solid contents were 57.5 g.

### (Production Example 7)

In a 1 liter flask, 57.2 g of 3,4-epoxycyclohexyl ethyl trimethoxy silane, 11.8 g of phenyl trimethoxy silane, 4.4 g of titanium propoxide, and 200 g of ethanol were placed. And 16.9 g of ultra pure water was added thereto. This solution was stirred at 60 degrees C for an hour, and then 300 g of propylene glycol monomethyl ether acetate was added thereto. The solution was stirred for 2 hours at 100 degrees C with evaporation. Then the solution was concentrated under a reduced pressure (10 hPa) to obtain a 220 g solution of polymer 7. Among the solution, solid contents were 52.4 g.

### (Production Example 8)

In a 1 liter flask, 595 g of ethanol and 75g of 10% aqueous solution of tetramethylammonium hydroxide were placed. And a mixture of 176 g of 3,4-epoxycyclohexyl ethyl trimethoxy silane and 35 g of phenyl trimethoxy silane was added thereto under nitrogen atmosphere at 30 degrees C. After a lapse of an hour, to the solution was added 27.5 g of acetic acid, and then ethanol and methanol were evaporated under a reduced pressure (100 hPa). To this remained solution was added 200 g of ethyl acetate and a water layer was separated. Then a step of washing an organic layer by adding 240 g of ultrapure water to the layer was repeated three times. To the organic layer was added 600 g of propylene glycol monomethyl ether acetate, and this solution was concentrated under a reduced pressure (20 hPa) to obtain a 600 g solution of polymer 8. Among the solution, solid contents were 149.9 g.

### (Production Example 9)

In a 1 liter flask, 595 g of ethanol, 33 g of methanol solution containing 30% of titanium oxide sol (product name: Optlake manufactured by CATALYSTS&CHEMICALS IND.CO., LTD.), 3 g of oxalic acid, and 177 g of ultrapure water were placed. And a mixture of 176 g of 3,4-epoxycyclohexyl ethyl trimethoxy silane and 35 g of phenyl trimethoxy silane was added thereto at 30 degrees C, and mixed sufficiently. After a lapse of an hour, ethanol and methanol were evaporated under a reduced pressure (100 hPa). To this remained solution was added 200 g of ethyl acetate and a water layer was separated. Then a step of washing an organic layer by adding 240 g of ultrapure water to the layer was repeated three times. To the organic layer was added 120 g of acetylacetone and 600 g of propylene glycol monomethyl ether acetate, and this solution was concentrated under a reduced pressure (20 hPa) to obtain a 600 g solution of polymer 9 (a composition of siloxane resin and titanium oxide sol). Among the solution, solid contents were 175 g.

Raw material compositions. of the Production Examples 1 to 9 were summarized in the following Table 1.

Incidentally, in Table 1, Monomer 1 represents phenyl trimethoxy silane; Monomer 2 represents 3,4-epoxycyclohexyl ethyl trimethoxy silane; Monomer 3 represents tetraethoxy silane; and Monomer 4 represents methyltrimethoxy silane.

In Table 1, Si Amount (mass %) and Ti Amount (mass %) represent mass ratio of silicon atoms and titanium atoms in a polymer when all hydrolysable groups of silane and titanium described as main raw material in Table 1 turn into Si-O-Si. Crosslinkable Group Amount represents amount of organic crosslinkable groups in 1 g of a polymer when all hydrolysable groups of silane and titanium described as main raw material in Table 1 turn into Si-O-Si. Yield (mass %) represents mass ratio of actually obtained solid contents to a polymer when all hydrolysable groups of silane and titanium described as main raw material in Table 1 turn into Si-O-Si, Ti-O-Ti, or Si-O-Ti. Furthermore, Parts represents parts by mass to 100 parts of a polymer when all hydrolysable groups of silane and titanium described as main raw material in Table 1 turn into Si-O-Si.

| | Composition of Main Raw Material | | | | | | | | | | | |
|---|---|---|---|---|---|---|---|---|---|---|---|---|
| | (mole %) | | | | | (Parts) | Hydrolysis Water | Terminal Domain Blocker | Yield | Si Amount | Ti Amount | Crosslinkable Group Amount |
| | Monomer 1 | Monomer 2 | Monomer 3 | Monomer 4 | Ti (OPr), | Titanium Oxide Sol | H₂O/OR (mole ratio) | | (mass%) | (mass%) | (mass%) | (mmol/g) |
| Production Example 1 | 19.4 | 75.6 | - | - | 5.0 | - | 1.0 | acetylacetone | 120 | 16.3 | 1.48 | 4.64 |
| Production Example 2 | 17.3 | 57.8 | - | - | 25.0 | - | 1.0 | acetylacetone | 135 | 14.5 | 8.35 | 3.99 |
| Production Example 3 | 13.2 | 26.8 | - | - | 60 | - | 1.0 | acetylacetone | 170 | 9.9 | 25.75 | 2.38 |
| Production Example 4 | 12.0 | 23.0 | - | 50.0 | 15.0 | - | 1.0 | acetylacetone | 127 | 23.4 | 7.13 | 2.26 |
| Production Example 5 | 11.5 | 23.5 | 50.0 | - | 15.0 | - | 1.0 | acetylacetone | 127 | 24.2 | 7.38 | 2.34 |
| Production Example 6 | 19.4 | 75.6 | - | - | 5.0 | - | 1.0 | Trimethylmethoxy silane | 115 | 16.3 | 48 | 4.64 |
| Production Example 7 | 19.4 | 75.6 | - | - | 5.0 | - | 1.0 | - | 105 | 16.3 | 1.48 | 4.64 |
| Production Example 8 | 20 | 80 | - | - | - | - | 4.0 | - | 100 | 16.7 | 0 | 4.78 |
| Production Example 9 | 20.0 | 80.0 | - | | - | 11 | 4.0 | - | 100 | 15.2 | 4.30 | 4.45 |

### (Production Example 10)

In a 5 liter flask, 915 g of ultrapure water, 1884 g of ethanol and 103g of 10% aqueous solution of tetramethylammonium hydroxide were placed. And a mixture of 434 g of methyl trimethoxy silane and 662 g of tetraethoxy silane was added thereto under nitrogen atmosphere at 40 degrees C. After a lapse of four hours, to the solution was added 10 g of acetic acid, and then 1800 g of propylene glycol monomethyl ether acetate was added. Then ethanol and methanol were evaporated under a reduced pressure (100 hPa). To this remained solution was added 1200 g of ethyl acetate and a water layer was separated. Then a step of washing an organic layer by adding 1200 g of ultrapure water to the layer was repeated three times. To the organic layer was added 2400 g of propylene glycol monopropyl ether, and this solution was concentrated under a reduced pressure (20 hPa) to obtain a 2400 g solution of polymer 10. Among the solution, solid contents were 16.4 mass %.

### (Examples and Comparative Examples)

### [Preparation of Antireflection Film Composition]

Each solution of antireflection film composition was prepared as follows. To each polymer solution obtained in Production Examples 1 to 9 were added an acid generator, a crosslinker, and a surfactant according to compositions shown in the following Table 2. This solution was diluted with a solvent so that solid contents (the polymer, the acid generator, and the crosslinker) became 5 mass %, and filtered through a 0.02 µm pore filtration film made of PE.

Each composition in Table 2 is as follows.
Polymer 1 to Polymer 9: obtained from Production Examples 1 to 9 Crosslinker: HMM (see the following structural formula) 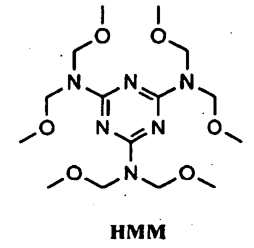 Acid Generator: BBI-109 (an acid generator manufactured by Midori Kagaku Co.,Ltd.)
Surfactant: FC-4430 (a surfactant manufactured by 3M) Organic Solvent: PGMEA (propylene glycol monomethyl ether acetate)

### [Evaluation of Refractive Index]

Antireflection films 800 angstroms thick (80 nm) were formed by applying the antireflection film compositions prepared above on silicon substrates and baking the compositions at 180 degrees C for 90 seconds, respectively.

After formation of the antireflection films, the refractive index (n, k) of the antireflection films at a wavelength of 193 nm were measured with an incident light angle variable spectroscopic ellipsometer (VASE) manufactured by J.A. Woollam Co., Inc. The results were also shown in Table 2.

**[Table 2]**

| | Composition (mass %) | | | | | | Refractive Index (193nm) | |
|---|---|---|---|---|---|---|---|---|
| | Polymer Solution | Polymer (Solid Content) | Crosslinker | Acid Generator | Surfactant | Organic Solvent | n value | k value |
| Example 1 | Polymer 1 | 9.0 | 0.9 | 0.1 | 0.1 | PGMEA | 1.78 | 0.22 |
| Example 2 | polymer 2 | 9.0 | 0.9 | 0.1 | 0.1 | PGMEA | 1.82 | 0.25 |
| Example 3 | polymer 4 | 9.0 | 0.9 | 0.1 | 0.1 | PGMEA | 1.78 | 0.20 |
| Example 4 | polymer 5 | 9.0 | 0.9 | 0.1 | 0.1 | PGMEA | 1.78 | 0.21 |
| Example 5 | polymer 9 | 9.0 | 0.9 | 0.1 | 0.1 | PGMEA | 1.77 | 0.19 |
| Comparative Example 1 | polymer 3 | 9.0 | 0.9 | 0.1 | 0.1 | PGMEA | 1.77 | 0.19 |
| Comparative Example 2 | polymer 6 | 9.0 | 0.9 | 0.1 | 0.1 | PGMEA | 1.76 | 0.21 |
| Comparative Example 3 | polymer 7 | 9.0 | 0.9 | 0.1 | 0.1 | PGMEA | 1.75 | 0.20 |
| Comparative Example 4 | polymer 8 | 9.0 | 0.9 | 0.1 | 0.1 | PGMEA | 1.73 | 0.20 |

As shown in Table 2, n value of refractive index falls within the range of 1.5 to 1.9, and k value of refractive index falls within the range of 1.5 or greater in Examples and Comparative Examples. Consequently, Examples and Comparative Examples provide sufficient antireflection effect.

### [Preparation of Photoresist Film Composition]

The following polymer (polymer A) was prepared as a base resin for ArF photoresist film composition.

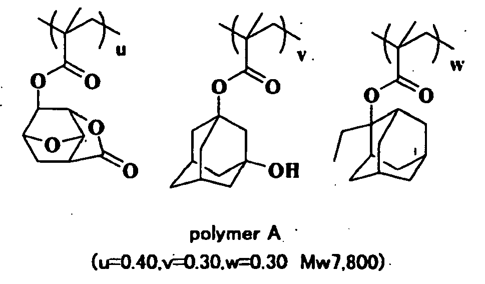

A photoresist film composition for ArF lithography (ArF single layer resist polymer A solution) was prepared with the polymer prepared above (polymer A) according to composition shown in the following Table 3.

Each of the compositions in Table 3 is as follows.

Acid generator: PAG1 (see the following structural formula) 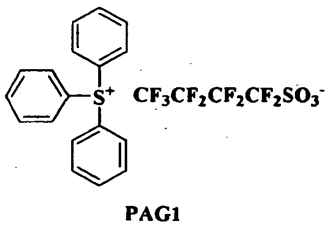 Organic solvent: PGMEA (propylene glycol monomethyl ether acetate)

**[Table 3]**

| Polymer (parts by mass) | Acid Generator (parts by mass) | Organic Solvent (parts by mass) |
|---|---|---|
| ArF Single Layer Resist Polymer A (100) | pAG1 (4.0) | PGMEA (1,200) |

### [Observation of Resist Pattern Profile]

Antireflection films 800 angstroms thick (80 nm) were formed by applying the antireflection film compositions prepared above (Examples 1 to 5 and Comparative Examples 1 to 4 in Table 2) on silicon substrates and baking the compositions at 180 degrees C for 90 seconds, respectively.

Then photoresist layers 1900 angstroms thick (190 nm) were formed on the antireflection films by applying the ArF single layer resist polymer A solution prepared above on the antireflection films and baking the solution at 130 degrees C for 60 seconds, respectively.

Subsequently, the substrate was exposed with ArF exposure system (S305B, NA 0.68, σ 0.85, 2/3 annular illumination, a Cr mask, manufactured by Nikon Corporation), baked (PEB) for 60 seconds at 110 degrees C, and developed in 2.38 mass % aqueous solution of tetramethylammonium hydroxide (TMAH), to obtain a positive pattern. Results of observation of thus-obtained pattern profile of 0.08 µm L/S were shown in the following Table 4.

**[Table 4]**

| Antireflection Film Composition | Film Thickness Variation of Antireflection Film (σ) | Photoresist Film Composition | Resist Pattern Profile (Line and Space) |
|---|---|---|---|
| Example 1 | 1.7 | ArF Single Layer Resist Polymer A Solution | Straight Wall Profile No Footing Profile |
| Example 2 | 3.5 | ArF Single Layer Resist Polymer A Solution | Straight Wall Profile No Footing Profile |
| Example 3 | 2.2 | ArF Single Layer Resist Polymer A Solution | Straight Wall Profile No Footing Profile |
| Example 4 | 2.2 | ArF Single Layer Resist Polymer A Solution | Straight Wall Profile No Footing Profile |
| Example 5 | 1.2 | ArF Single Layer Resist Polymer A Solution | Straight Wall Profile No Footing Profile |
| Comparative Example 1 | incapable measurement because application unevenness was detected with visual inspection | ArF Single Layer Resist Polymer A Solution | Straight Wall Profile Footing Profile |
| Comparative Example 2 | 2.4 | ArF Single Layer Resist Polymer A Solution | Straight Wall Profile No Footing Profile |
| Comparative Example 3 | 2.8 | ArF Single Layer Resist Polymer A Solution | Straight Wall Profile No Footing Profile |
| Comparative Example 4 | 1.8 | ArF Single Layer Resist Polymer A Solution | Straight Wall Profile No Footing Profile |

From the results of Table 4, it was found that no pattern collapse or separation of resist layers were observed in Examples and Comparative Examples, and all Examples and Comparative Examples have sufficient adhesion property. Each profile of patterned resist films is straight wall profile, and thus antireflection film compositions according to the present invention forming intermediate resist films obviously provide sufficient antireflection effect. In Comparative Example 1 having high titanium content, uneven surface of an antireflection film and footing profile due to intermixing at an interface of the antireflection film and a resist film were observed.

### [Tests of Etching Resistance]

### (1) Etching Test with CHF₃/CF₄ gas

Antireflection films 800 angstroms thick (80 nm) were formed by applying the antireflection film compositions prepared above (Examples 1 to 5 and Comparative Examples 1 to 4 in Table 2) on silicon substrates and baking the compositions at 180 degrees C for 90 seconds, respectively.

A photoresist layer 1900 angstroms thick (190 nm) was formed on a silicon substrate by applying the ArF single layer resist polymer A solution on the silicon substrate and baking the solution at 130 degrees C for 60 seconds.

Etching rates of the antireflection films and the photoresist layer were measured with dry-etching-system TE-8500S manufactured by Tokyo Electron, Ltd.

The etching conditions were as follows.
Chamber pressure: 40.0 Pa
RF power: 1,000 W
Gap: 9 mm
CHF₃ gas flow rate: 30 ml/min
CF₄ gas flow rate: 30 ml/min
Ar gas flow rate: 100 ml/min
Time: 55 sec

Obtained results are shown in the following Table 5.

**[Table 5]**

| Film Composition | Etching Rate with CHF₃/CF₄ Gas (Angstrom/min) (nm/min) |
|---|---|
| Example 1 | 1510 (151.0) |
| Example 2 | 1490 (149.0) |
| Example 3 | 2100 (210.0) |
| Example 4 | 2320 (232.0) |
| Example 5 | 1550 (155.0) |
| Comparative Example 1 | 1307 (130.7) |
| Comparative Example 2 | 1421 (142.1) |
| Comparative Example 3 | 1403 (140.3) |
| Comparative Example 4 | 1381 (138.1) |
| ArF Single Layer Resist Polymer A Solution | 1464 (146.4) |

As is evident from Table 5, etching rates of antireflection films formed with antireflection film compositions according to the present invention (Examples 1 to 5) are higher than that of the photoresist film.

### (2) Etching Test with O₂ gas

Antireflection films 800 angstroms thick (80 nm) were formed by applying the antireflection film compositions prepared above (Examples 1 to 5 and Comparative Examples 1 to 4 in Table 2) on silicon substrates and baking the compositions at 180 degrees C for 90 seconds, respectively.

### (Preparation of Lower Resist Film Composition)

As a base resin for a lower resist film composition, propylene glycol monomethyl ether acetate solution was prepared to contain 4,4'-(9H-fluorene-9-ylidene) bisphenol novolac resin (molecular weight: 11,000, see Japanese Unexamined Patent Application Publication No. 2005-128509) in the proportions of 28 parts of the resin to 100 parts of the solvent.

A lower resist film 3000 angstroms thick (300 nm) was formed on a silicon substrate by applying thus-obtained lower resist film composition on the silicon substrate and baking the composition at 200 degrees C for 60 seconds.

The antireflection films and the lower resist film were etched with O₂ gas, and etching rates were measured.

The etching conditions were as follows.
Chamber pressure: 40.0 Pa
RF power: 600 W
Time: 60 sec

Obtained results are shown in the following Table 6.

**[Table 6]**

| Film Composition | Etching Rate with O₂ Gas (Angstrom/min) (nm/min) |
|---|---|
| Example 1 | 180 (18.0) |
| Example 2 | 30 (3.0) |
| Example 3 | 97 (9.7) |
| Example 4 | 110 (11.0) |
| Example 5 | 154 (15.4) |
| Comparative Example 1 | Separation occurred |
| Comparative Example 2 | 190 (19.0) |
| Comparative Example 3 | 172 (17.2) |
| Comparative Example 4 | 154 (15.4) |
| Lower Resist Film Composition | 2800 (280.0) |

As shown in Table 6, the antireflection films formed with antireflection film compositions according to present invention (Examples 1 to 5) have higher etching resistance than the lower resist film when the films are etched with O₂ gas. Therefore, the antireflection films can be used as etching masks for the lower resist film.

### [Tests of Wet Stripping]

Antireflection films 800 angstrom thick (80 nm) were formed by applying the antireflection film compositions prepared above (Examples 1 to 5 and Comparative Examples 1 to 4 in Table 2) on silicon substrates and baking the compositions at 180 degrees C for 90 seconds, respectively.

A silica insulator film (a low dielectric constant film) 2000 angstrom thick (200 nm) was formed by applying the low dielectric constant film composition prepared in Production Example 10 and baking the composition at 425 degrees C for an hour. Dielectric constant of the film was measured with IV/CV measuring device SSM495 manufactured by SSM Japan, and the result was 2.50.

Furthermore, an Si wafer was prepared.

The antireflection films, the low dielectric constant film, and the Si wafer were immersed in a chemical solution for a given length of time, and then remained film thickness (angstrom) of the films and the wafer were measured. Incidentally, the tests were conducted under the following conditions with different types of chemical solutions and different temperature of chemical solutions.
(1) Chemical Solution
   Name: AP811 manufactured by ATMI
   Main Composition: hydrofluoric acid
   Temperature of Chemical Solution: 35 degrees C
(2) Chemical Solution
   Name: ACT691 manufactured by Air Products
   Main Composition: amine
   Temperature of Chemical Solution: 50 degrees C

Results with the condition (1) are shown in the following Table 7.

**[Table 7]**

| | Remained Film Thickness (Angstrom) (1 Å = 0.1 nm) | | | | |
|---|---|---|---|---|---|
| Immersion Time(min) | 0.5 | 1 | 2 | 5 | 10 |
| Example 1 | 289 | 198 | 106 | 40 | 21 |
| Example 2 | 41 | 23 | 22 | 16 | 14 |
| Example 3 | 57 | 38 | 25 | 17 | 15 |
| Example 4 | 69 | 45 | 22 | 16 | 16 |
| Example 5 | 80 | 24 | 16 | 16 | 16 |
| Comparative Example 1 | 16 | 15 | 16 | 15 | 14 |
| Comparative Example 2 | 292 | 208 | 112 | 52 | 20 |
| Comparative Example 3 | 280 | 212 | 110 | 42 | 18 |
| Comparative Example 4 | 804 | 801 | 801 | 803 | 801 |
| Low Dielectric Constant Film | - | - | - | - | 2002 (Dielectric Constant :2.54) |
| Si wafer | 16 | 16 | 16 | 16 | 16 |

Results with the condition (2) are shown in the following Table 8.

**[Table 8]**

| | Remained Film Thickness (Angstrom) (1 Å = 0.1 nm) | | | | |
|---|---|---|---|---|---|
| Immersion Time (min) | 0.5 | 1 | 2 | 5 | 10 |
| Example 1 | 25 | 22 | 20 | 18 | 17 |
| Example 2 | 40 | 33 | 18 | 16 | 16 |
| Example 3 | 34 | 20 | 17 | 17 | 16 |
| Example 4 | 41 | 20 | 16 | 17 | 16 |
| Example 5 | 52 | 38 | 20 | 16 | 16 |
| Comparative Example 1 | 22 | 20 | 17 | 16 | 15 |
| Comparative Example 2 | 23 | 21 | 20 | 16 | 17 |
| Comparative Example 3 | 23 | 21 | 19 | 17 | 15 |
| Comparative Example 4 | 800 | 790 | 782 | 766 | 698 |
| Low Dielectric Constant Film | - | - | - | - | 1953 (Dielectric Constant :2.69) |
| Si wafer | 15 | 16 | 16 | 15 | 16 |

As shown in Table 7, antireflection films containing titanium according to the present invention can be dissolved and removed without damaging a low dielectric constant insulator film.

As shown in Table 8, in the case of the condition (2) using the chemical solution having higher stripping ability, an antireflection film without containing titanium are dissolved slowly (Comparative Example 4). However, the low dielectric constant insulator film is simultaneously eroded and degenerated. Therefore, the antireflection film cannot be removed selectively.

### [Evaluation of Preservation Stability]

Film thickness variation of the antireflection film compositions prepared above (Examples 1 to 5 and Comparative Examples 1 to 4 in Table 2) over time were measured.
Application Condition: 2500 rpm
Hardening Condition: 180 degrees C/ 90 seconds
Preservation condition of application solution: 25 degrees C for a month

Obtained results are shown in the following Table 9.

**[Table 9]**

| Antireflection Film Composition | Initial Film Thickness (Angstrom)^{*} | Film Thickness After One Month (Angstrom)^{*} | Increasing Rate (%) |
|---|---|---|---|
| Example 1 | 730 | 741 | 1.5 |
| Example 2 | 708 | 720 | 1.7 |
| Example 3 | 857 | 876 | 2.2 |
| Example 4 | 880 | 915 | 4.0 |
| Example 5 | 969 | 972 | 0.3 |
| Comparative Example 1 | 660 | 665 | 0.8 |
| Comparative Example 2 | 755 | 1336 Even film cannot be formed due to generation of microgel | 74.2 |
| Comparative Example 3 | 767 | 1401 Even film cannot be formed due to generation of microgel | 82.7 |
| Comparative Example 4 | 890 | 893 | 0.3 |

| | | | |
|---|---|---|---|
| * 1 Å = 0.1 nm | | | |

As shown in Table 9, film thickness variations in Examples 1 to 5 and Comparative Example 1 are small, while partial gelation is caused in Comparative Examples 2 and 3. Therefore, these results demonstrate that chelation of titanium enhances preservation stability.

The present invention is not limited to the above-described embodiments. The above-described embodiments are mere examples, and those having the substantially same structure as that described in the appended claims and providing the similar action and advantages are included in the scope of the present invention.

## Claims

1. An antireflection film composition for forming an intermediate resist film in a multilayer resist element used in lithography comprising: at least
a polymer obtained by reacting a chelating agent with a polymer having a repeating unit represented by the following general formula (1), 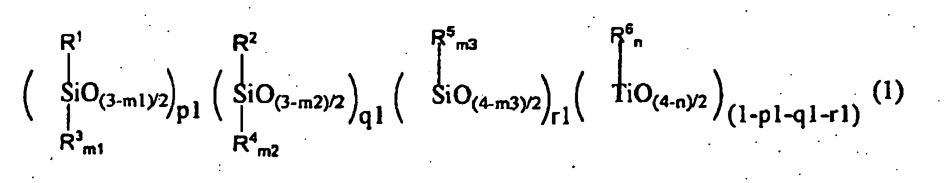 ,wherein R¹ represents a monovalent organic group that reacts with crosslinker and/or any one or more of the organic groups R², R³, R⁴ and R⁶ to form crosslinking; R² represents a monovalent organic group having a light absorbing group; R⁵ represents the same or different group that does not crosslink with crosslinker or organic groups in the formula (1); p1, q1 and r1 satisfy 0<p1<1, 0<qi<1, 0≤r1<1 and 0.5<p1+q1+r1<1; R³ represents any one of a hydroxy group, an alkyl group having 1-6 carbon atoms, an alkoxy group having 1-4 carbon atoms, and the same groups as defined for R² or R⁵; R⁴ represents the same groups as defined for R¹, R³ or R⁵; m1 satisfies 0≤m1≤1; m2 satisfies 0≤m2≤1; m3 satisfies 0≤m3≤2; R⁶ independently represents an alkoxy group having 1-6 carbon atoms or a hydroxy group; and n satisfies 0≤n≤3;
an organic solvent; and
an acid generator.

2. An antireflection film composition for forming an intermediate resist film in a multilayer resist element used in lithography comprising: at least
a composition obtained by reacting a chelating agent with a composition containing a polymer having a repeating unit represented by the following general formula (2) and titanium oxide sol in the proportions of 100 parts of the polymer to 1-50 parts of the sol, 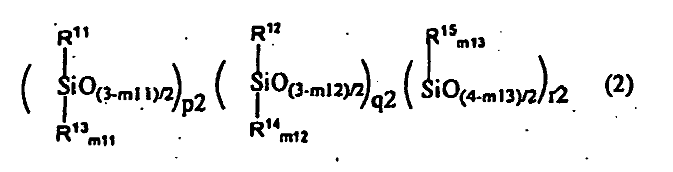 ,wherein R¹¹ represents a monovalent organic group that reacts with crosslinker and/or any one or more of the organic groups R¹², R¹³ and R¹⁴ to form crosslinking; R¹² represents a monovalent organic group having a light absorbing group; R¹⁵ represents the same or different group that does not crosslink with crosslinker or organic groups in the formula (2); p2, q2 and r2 satisfy 0<p2<1, 0<q2<1, 0≤r2<1 and 0<p2+q2+r2≤1; R¹³ represents any one of a hydroxy group, an alkyl group having 1-6 carbon atoms, an alkoxy group having 1-4 carbon atoms, and the same groups as defined for R¹² or R¹⁵; R¹⁴ represents the same groups as defined for R¹¹, R¹³ or R¹⁵; m11 satisfies 0≤m11≤1; m12 satisfies 0≤m12≤1; and m13 satisfies 0≤m13≤2;
an organic solvent; and
an acid generator.

3. The antireflection film composition according to Claim 1 or Claim 2, wherein the chelating agent is selected from beta-diketones.

4. The antireflection film composition according to Claim 1 or Claim 3, wherein R² in the general formula (1) has a phenyl group.

5. The antireflection film composition according to Claim 2 or Claim 3, wherein _{R}12 in the general formula (2) has a phenyl group.

6. A patterning process for patterning a substrate with lithography comprising: at least
forming an organic film (23) over a substrate (22) as a lower resist film;
applying the antireflection film composition according to any one of Claims 1 to 5 over the lower resist film, and baking the composition to form an antireflection film (20) as an intermediate resist film;
applying a photoresist film composition over the intermediate resist film, and prebaking the composition to form a photoresist film (21) as an upper resist film;
exposing a pattern circuit area of the upper resist film and then developing the film with a developer to form a resist pattern on the upper resist film;
etching the intermediate resist film with using the upper resist film on which the resist pattern is formed as a mask;
etching the lower resist film with using the patterned intermediate resist film as a mask; and
etching the substrate (22) with using the lower resist film as a mask.

7. The patterning process according to Claim 6, wherein a process layer (22a) of the substrate (22) to be patterned is a low dielectric constant film having a dielectric constant of 3.8 or less.

8. The patterning process according to Claim 6 or Claim 7, wherein the intermediate resist film is removed with wet stripping after being patterned.

9. A multilayer resist element comprising at least an organic film (23), an antireflection film (20) over the organic film (23), and a photoresist film (21) over the antireflection film (20), wherein the antireflection film (20) is formed by applying the antireflection film composition according to any one of Claims 1 to 5 over the organic film (23), and baking the composition,

## Patentansprüche

1. Antireflexionsschicht-Zusammensetzung zur Bildung einer Zwischen-Resistschicht in einem mehrschichtigen Resistelement, das bei der Lithographie verwendet wird, umfassend: mindestens
ein Polymer, das durch Reaktion eines Chelatbildners mit einem Polymer erhalten wird, das eine sich wiederholende Einheit aufweist, welche durch folgende allgemeine Formel (1) dargestellt wird 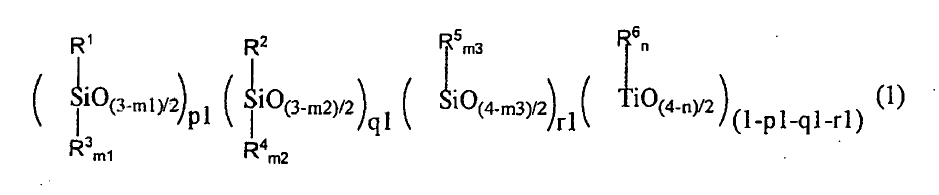 , wobei R¹ eine monovalente organische Gruppe darstellt, die mit einem Quervernetzer und/oder einer oder mehreren beliebigen der organischen Gruppen R², R³, R⁴ und R⁶ reagiert, so dass eine Quervernetzung entsteht; R² eine monovalente organische Gruppe darstellt, die eine lichtabsorbierende Gruppe aufweist; R⁵ die gleiche oder eine davon verschiedene Gruppe darstellt, die nicht mit einem Quervernetzer oder organischen Gruppen aus der Formel (1) eine Quervernetzung bildet; p1, q1 und r1 die Relationen 0<p1<1, 0<q1<1, 0≤r1<1 und 0,5<p1+q1+r1<1 erfüllen; R³ eine beliebige Gruppe darstellt aus einer Hydroxylgruppe, einer Alkylgruppe, die 1-6 Kohlenstoffatome aufweist, einer Alkoxygruppe, die 1-4 Kohlenstoffatome aufweist und den gleichen Gruppen, wie sie für R² oder R⁵ definiert sind; R⁴ die gleichen Gruppen darstellt, wie sie für R¹, R³ oder R⁵ definiert sind; m1 die Relation 0≤m1≤1 erfüllt; m2 die Relation 0≤m2≤1 erfüllt; m3 die Relation 0≤m3≤2 erfüllt; R⁶ unabhängig davon eine Alkoxygruppe, die 1-6 Kohlenstoffatome aufweist, oder eine Hydroxylgruppe darstellt; und n die Relation 0≤n≤3 erfüllt;
ein organisches Lösungsmittel; und
einen Säurebildner.

2. Antireflexionsschicht-Zusammensetzung zur Bildung einer Zwischen-Resistschicht in einem mehrschichtigen Resistelement, das bei der Lithographie verwendet wird, umfassend: mindestens
eine Zusammensetzung, die durch Reaktion eines Chelatbildners mit einer Zusammensetzung erhalten wird, die ein Polymer enthält, das eine sich wiederholende Einheit aufweist, welche durch folgende allgemeine Formel (2) dargestellt wird, und Titanoxid-Sol in Anteilen von 100 Teilen Polymer zu 1-50 Teilen Sol, 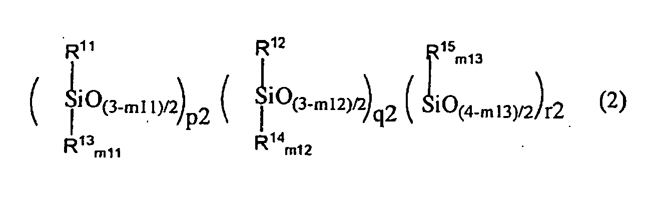 , wobei R¹¹ eine monovalente organische Gruppe darstellt, die mit einem Quervernetzer und/oder einer oder mehreren beliebigen der organischen Gruppen R¹², R¹³ und R¹⁴ reagiert, so dass eine Quervernetzung entsteht; R¹² eine monovalente organische Gruppe darstellt, die eine lichtabsorbierende Gruppe aufweist; R¹⁵ die gleiche oder eine davon verschiedene Gruppe darstellt, die nicht mit einem Quervernetzer oder organischen Gruppen aus der Formel (1) eine Quervernetzung bildet; p2, q2 und r2 die Relationen 0<p2<1, 0<q2<1, 0≤r2<1 und 0<p2+q2+r2<1 erfüllen; R¹³ eine beliebige Gruppe darstellt aus einer Hydroxylgruppe, einer Alkylgruppe, die 1-6 Kohlenstoffatome aufweist, einer Alkoxygruppe, die 1-4 Kohlenstoffatome aufweist und den gleichen Gruppen, wie sie für R¹² oder R¹⁵ definiert sind; R¹⁴ die gleichen Gruppen darstellt, wie sie für R¹¹, R¹³ oder R¹⁵ definiert sind; m11 die Relation 0≤m11≤1 erfüllt; m12 die Relation 0≤m12≤1 erfüllt; m13 die Relation 0≤m13≤2 erfüllt;
ein organisches Lösungsmittel; und
einen Säurebildner.

3. Antireflexionsschicht-Zusammensetzung gemäß Anspruch 1 oder Anspruch 2, wobei der Chelatbildner aus beta-Diketonen ausgewählt ist.

4. Antireflexionsschicht-Zusammensetzung gemäß Anspruch 1 oder Anspruch 3, wobei R² aus der allgemeinen Formel (1) eine Phenylgruppe aufweist.

5. Antireflexionsschicht-Zusammensetzung gemäß Anspruch 2 oder Anspruch 3, wobei R¹² aus der allgemeinen Formel (2) eine Phenylgruppe aufweist.

6. Mustergebungsverfahren, um ein Substrat mittels Lithographie mit einem Muster zu versehen, umfassend: mindestens
Bildung einer organischen Schicht (23) über einem Substrat (22) als untere Resistschicht;
Auftragen der Antireflexionsschicht-Zusammensetzung gemäß einem der Ansprüche 1 bis 5 über der unteren Resistschicht und Backen der Zusammensetzung, um eine Antireflexionsschicht (20) als Zwischen-Resistschicht zu bilden;
Auftragen einer Photoresistschicht-Zusammensetzung über der Zwischen-Resistschicht und Vorbacken der Zusammensetzung, um eine Fotoresistschicht (21) als obere Resistschicht zu bilden;
Belichten eines Schaltungsmusterbereiches der oberen Resistschicht und
anschließend Entwickeln der Schicht mit einem Entwickler, um ein Resistmuster auf der oberen Resistschicht zu bilden;
Ätzen der Zwischen-Resistschicht unter Verwendung der oberen Resistschicht, auf der das Resistmuster gebildet wurde, als Maske;
Ätzen der unteren Resistschicht unter Verwendung der mit einem Muster versehenen Zwischen-Resistschicht als Maske; und
Ätzen des Substrats (22) unter Verwendung der unteren Resistschicht als Maske.

7. Mustergebungsverfahren gemäß Anspruch 6, wobei eine Prozessschicht (22a) des mit einem Muster zu versehenden Substrats (22) eine Schicht mit einer geringen dielektrischen Konstante ist, welche eine dielektrische Konstante von 3,8 oder weniger besitzt.

8. Mustergebungsverfahren gemäß Anspruch 6 oder 7, wobei die Zwischen-Resistschicht durch Nassentfernung (wet stripping) entfernt wird, nachdem sie mit einem Muster versehen wurde.

9. Mehrschichtiges Resistelement, das mindestens eine organische Schicht (23), eine Antireflexionsschicht (20) über der organischen Schicht (23), und eine Photoresistschicht (21) über der Antireflexionsschicht (20) umfasst, wobei die Antireflexionsschicht (20) durch Auftragen der Antireflexionsschicht-Zusammensetzung gemäß einem der Ansprüche 1 bis 5 über der organischen Schicht (23) und Backen der Zusammensetzung gebildet wird.

## Revendications

1. Composition de film antireflet destinée à former un film d'épargne intermédiaire au sein d'un élément d'épargne multicouche utilisé en lithographie comprenant : au moins
un polymère obtenu en faisant réagir un agent de chélation avec un polymère comportant une unité répétitive représentée par la formule générale (1) suivante, 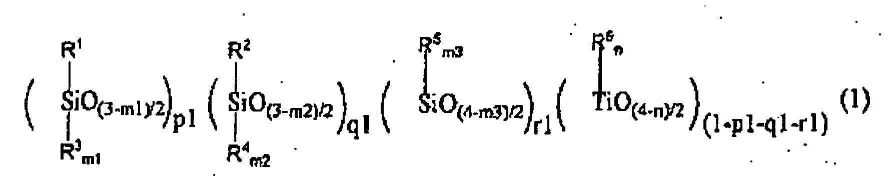 dans laquelle R¹ représente un groupement organique monovalent qui réagit avec un agent de réticulation et/ou l'un quelconque ou plusieurs parmi les groupements organiques R², R³, R⁴ et R⁶ pour former une réticulation ; R² représente un groupement organique monovalent comportant un groupement absorbant la lumière ; R⁵ représente le même groupement ou un groupement différent qui ne réticule pas avec l'agent de réticulation ou les groupements organiques se trouvant dans la formule (1) ; p1, q1 et r1 satisfont à 0 < p1 < 1, 0 < q1 < 1, 0 ≤ r1 < 1 et 0,5 < p1 + q1 + r1 < 1; R³ représente l'un quelconque parmi un groupement hydroxy, un groupement alkyle comportant 1 à 6 atomes de carbone, un groupement alcoxy comportant 1 à 4 atomes de carbone, ainsi que les mêmes groupements que définis pour R² ou R⁵ ; R⁴ représente les mêmes groupements que définis pour R¹, R³ ou R⁵ ; m1 satisfait à 0 ≤ m1 ≤ 1 ; m2 satisfait à 0 ≤ m2 ≤ 1 ; m3 satisfait à 0 ≤ m3 ≤ 2 ; R⁶ représente indépendamment un groupement alcoxy comportant 1 à 6 atomes de carbone ou un groupement hydroxy ; et n satisfait à 0 ≤ n ≤ 3 ;
un solvant organique ; et
un générateur d'acide.

2. Composition de film antireflet destinée à former un film d'épargne intermédiaire au sein d'un élément d'épargne multicouche utilisé en lithographie comprenant : au moins
une composition obtenue en faisant réagir un agent de chélation avec une composition contenant un polymère comportant une unité répétitive représentée par la formule générale (2) qui suit et un sol d'oxyde de titane dans les proportions de 100 parties du polymère pour 1 à 50 parties du sol, 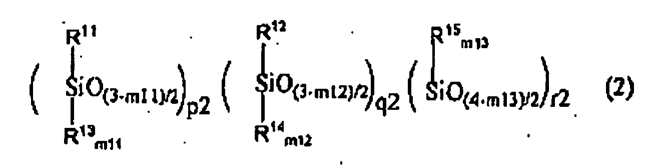 dans laquelle R¹¹ représente un groupement organique monovalent qui réagit avec un agent de réticulation et/ou l'un quelconque ou plusieurs parmi les groupements organiques R¹², R¹³ et R¹⁴ pour former une réticulation ; R¹² représente un groupement organique monovalent comportant un groupement absorbant la lumière ; R¹⁵ représente le même groupement ou un groupement différent qui ne réticule pas avec l'agent de réticulation ou les groupements organiques se trouvant dans la formule (2) ; p2, q2 et r2 satisfont à 0 < p2 < 1, 0 < q2 < 1, 0 ≤ r2 < 1 et 0 < p2 + q2 + r2 ≤ 1; R¹³ représente l'un quelconque parmi un groupement hydroxy, un groupement alkyle comportant 1 à 6 atomes de carbone, un groupement alcoxy comportant 1 à 4 atomes de carbone, ainsi que les mêmes groupements que définis pour R¹² ou R¹⁵ ; R¹⁴ représente les mêmes groupements que définis pour R¹¹, R¹³ ou R¹⁵; m11 satisfait à 0 ≤ m11 ≤ 1 ; m12 satisfait à 0 ≤ m12 ≤ 1 ; et m13 satisfait à 0 ≤ m13 ≤ 2 ;
un solvant organique ; et
un générateur d'acide.

3. Composition de film antireflet selon la revendication 1 ou la revendication 2, dans lequel l'agent de chélation est choisi parmi les bêta-dicétones.

4. Composition de film antireflet selon la revendication 1 ou la revendication 3, dans lequel le R² se trouvant dans la formule générale (1) comporte un groupement phényle.

5. Composition de film antireflet selon la revendication 2 ou la revendication 3, dans lequel le R¹² se trouvant dans la formule générale (2) comporte un groupement phényle.

6. Processus de formation de motif destiné à former un motif sur un substrat à l'aide d'une lithographie comprenant : au moins
de former un film organique (23) sur un substrat (22) en tant que film d'épargne inférieur ;
d'appliquer la composition de film antireflet selon l'une quelconque des revendications 1 à 5 sur le film d'épargne inférieur, et de cuire la composition pour former un film antireflet (20) en tant que film d'épargne intermédiaire ;
d'appliquer une composition de film d'épargne photosensible sur le film d'épargne intermédiaire, et de pré-cuire la composition pour former un film d'épargne photosensible (21) en tant que film d'épargne supérieur ;
d'exposer une zone de circuit de motif du film d'épargne supérieur et ensuite de développer le film à l'aide d'un révélateur pour former un motif d'épargne sur le film d'épargne supérieur ;
de graver le film d'épargne intermédiaire en utilisant le film d'épargne supérieur sur lequel le motif d'épargne est formé en tant que masque ;
de graver le film d'épargne inférieur en utilisant le film d'épargne intermédiaire muni du motif en tant que masque ; et
de graver le substrat (22) en utilisant le film d'épargne inférieur en tant que masque.

7. Processus de formation de motif selon la revendication 6, dans lequel une couche de traitement (22a) du substrat (22) à doter d'un motif est un film de faible constante diélectrique possédant une constante diélectrique de 3,8 ou moins.

8. Processus de formation de motif selon la revendication 6 ou la revendication 7, dans lequel le film d'épargne intermédiaire est éliminé à l'aide d'un décapage humide après avoir été soumis à une formation de motif.

9. Élément d'épargne multicouche comprenant au moins un film organique (23), un film antireflet (20) sur le film organique (23) et un film d'épargne photosensible (21) sur le film antireflet (20), dans lequel le film antireflet (20) est formé en appliquant la composition de film antireflet selon l'une quelconque des revendications 1 à 5 sur le film organique (23), et en cuisant la composition.
